# EUROPEAN PATENT APPLICATION

(11) **EP 4 586 253 A1**
(43) Date of publication of application: **16.07.2025**
(21) Application number: 25150884.2
(22) Date of filing: 09.01.2025
(51) Int. Cl.: G11C 7/10, G11C 13/00, G11C 29/52, G11C 29/04

(54) **METHOD, DEVICE, AND APPARATUS WITH MEMORY REPAIR BASED ON EXCLUSIVE-OR**

(30) Priority: 09.01.2024 KR 20240003449; 04.04.2024 KR 20240046050
(71) Applicant: Samsung Electronics Co., Ltd., Suwon-si, Gyeonggi-do 16677 (KR)
(72) Inventor: Lee, Jaehyuk, 16678 Suwon-si, Gyeonggi-do (KR); Kwon, Soon-Wan, 16678 Suwon-si, Gyeonggi-do (KR); Yun, Seok Ju, 16678 Suwon-si, Gyeonggi-do (KR)
(74) Representative: Grünecker Patent- und Rechtsanwälte PartG mbB

(57) **Abstract**

A device including a memory array including N+1 resistive memory cells, the N+1 resistive memory cells including resistor values representing an N-bit sequence, the resistor values being determined based on a stuck resistor value of an error memory cell on a wordline including the error memory cell, the resistor values being set respectively and a write encoder configured to generate N+1 write signals respectively indicative of the resistor values to be set for the N+1 resistive memory cells, and N is an integer greater than or equal to 1.

## Description

### BACKGROUND

### 1. Field

The present disclosure relates to a device, apparatus, and method with memory repair based on exclusive-OR (XOR).

### 2. Description of Related Art

A semiconductor memory device may be classified into a volatile memory device that loses stored data when power supply is interrupted, and a non-volatile memory device that does not lose stored data even when power supply is interrupted. The volatile semiconductor memory device may be fast to read and write, but it may lose stored data when an external power supply is disconnected. In contrast, the non-volatile memory device may be relatively slower to read and write than the volatile memory device, but it may retain corresponding data even when an external power supply is disconnected.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is what is claimed in the independent claims. Preferred embodiments are specified in the dependent claims.

In a general aspect, here is provided an apparatus including a memory array including N+1 resistive memory cells, the N+1 resistive memory cells including resistor values representing an N-bit sequence, the resistor values being determined based on a stuck resistor value of an error memory cell on a wordline including the error memory cell, the resistor values being set respectively and a write encoder configured to generate N+1 write signals respectively indicative of the resistor values to be set for the N+1 resistive memory cells, and N is an integer greater than or equal to 1.

When bit value at a bit position in the bit sequence are a first bit value, resistor values of neighboring memory elements corresponding to the bit position among the N+1 resistive memory cells may be a same value and, when the bit value at the bit position is a second bit value, the resistor values of the neighboring memory elements corresponding to the bit position among the N+1 resistive memory cells may be different values.

The write encoder may include a plurality of exclusive-OR (XOR) elements configured to generate the N+1 write signals based on N bit signals respectively indicative of bit values of the bit sequence and on the stuck resistor value.

The write encoder may be configured to generate write signals for setting, for selected N+1 resistive memory cells of a wordline selected for writing, a resistor value combination matching the stuck resistor value of the error memory cell among two available resistor value combinations representing the bit sequence.

The write encoder may be configured to calculate a resistor value combination to be set for the N+1 resistive memory cells based on a magnitude of the stuck resistor value and a position of the error memory cell in the wordline.

The write encoder may include first XOR elements configured to generate write signals based on the stuck resistor value and the bit sequence and second XOR elements configured to generate inverse write signals, the inverse write signals being inverted from the write signals, in response to a value of a write signal corresponding to the error memory cell among the write signals being a different value from the stuck resistor value.

The second XOR elements may be configured to pass the write signals, in response to the value of the write signal corresponding to the error memory cell among the write signals being a same value as the stuck resistor value.

The apparatus may include reference write circuitry, the apparatus is further configured to set, for resistive memory cells of the memory array, resistor values of a first resistance state corresponding to a first bit value, determine, as the error memory cell, a resistive memory cell corresponding to a portion of the resistive memory cells from which a second bit value is read, from among the resistive memory cells, and manage the error memory cell as having a resistor value of a second resistance state.

The apparatus may be further configured to record, in error information, a value indicative of the wordline in which the error memory cell is located, a value indicative of a column line in which the error memory cell is located, and the stuck resistor value of the error memory cell.

The apparatus may be further configured to periodically update the error information using a first result of setting and reading a resistor value of a first resistance state and a second result of setting and reading a resistor value of a second resistance state, for a plurality of resistive memory cells of the memory array.

The apparatus may include a plurality of wordlines including the wordline, and a column line on which a first error memory cell of a first wordline among the plurality of wordlines is located and a column line on which a second error memory cell of a second wordline among the plurality of wordlines is located are different locations.

The apparatus may include read circuitry, the read circuitry being configured to generate bit read signals based on results of XOR performed on resistor values set for the N+1 resistive memory cells disposed along a wordline selected for reading.

Thee read circuitry may include an XOR element connected to two neighboring resistive memory cells among the N+1 resistive memory cells.

The read circuitry may be configured to output, as a bit value for the two neighboring resistive memory cells among the N+1 resistive memory cells, a result of comparing delays occurring in the two neighboring resistive memory cells, based on resistor values set for the two neighboring resistive memory cells and a parasitic capacitance.

In a general aspect, here is provided a processor-implemented method including generating N+1 write signals respectively indicative of N+1 resistor values representing an N-bit sequence, determined based on a stuck resistor value of an error memory cell on a wordline including the error memory cell of a memory array and setting resistor values according to the N+1 write signals for the N+1 resistive memory cells respectively.

The generating of the N+1 write signals may include generating the N+1 write signals based on N bit signals respectively indicative of bit values of the bit sequence and on the stuck resistor value, and N may be an integer greater than or equal to 1.

The generating of the N+1 write signals may include generating write signals indicative of a resistor value combination matching the stuck resistor value of the error memory cell among two available resistor value combinations representing the bit sequence.

The generating of the N+1 write signals may include inverting the write signals, in response to a value of an error write signal corresponding to the error memory cell among the write signals and the stuck resistor value being different values.

The method may include setting, for resistive memory cells of the memory array, resistor values of a first resistance state corresponding to a first bit value, determining, as the error memory cell, a resistive memory cell corresponding to a portion of the resistive memory cells from which a second bit value is read, from among the resistive memory cells, and managing the error memory cell as having a resistor value of a second resistance state.

The method may include generating N bit read signals based on results of an exclusive-OR (XOR) operation performed on resistor values set for the N+1 resistive memory cells disposed along a wordline selected for reading.

In a general aspect, here is provided a processor implemented method including selecting one memory cell, of N+1 memory cells connected to a wordline, having a reference resistor value from among the N+1 memory cells, setting a resistor value of the neighboring memory cell as the reference resistor value responsive to a bit value at a position, among the N bits, represented by resistor values of the selected one memory cell and a neighboring memory cell being a first value, and setting the resistor value of the neighboring memory cell as a value different from the reference resistor value responsive to the bit value at the position, among the N bits, represented by the resistor values of the selected one memory cell and the neighboring memory cell being a second value different from the first value.

The resistor value has a value encoded based on an exclusive -OR (XOR) in which the first value is zero (0) and the second value is 1.

The resistor value has a value encoded based on an exclusive-NOR (XNOR) in which the first value is 1 and the second value is 0.

N may be an integer greater than or equal to 2 and, when a bit value at a position is 0, resistor values of two neighboring memory cells representing the bit value at the position are a same value and, when the bit value at the position is 1, the resistor values of the two neighboring memory cells representing the bit value at the position are different values.

N may be an integer greater than or equal to 2, and, when a bit value at a position is 0, resistor values of two neighboring memory cells representing the bit value at the position are different values, and, when the bit value at the position is 1, the resistor values of the two neighboring memory cells representing the bit value at the position are a same value.

The one selected memory cell may be an error memory cell, the reference resistor value may be a stuck resistor value of the error memory cell, and N may be an integer greater than or equal to 1.

In a memory device including a plurality of wordlines, column positions of error memory cells of at least two wordlines may be different.

Other features and aspects will be apparent from the following detailed description, the drawings, and the claims.

### BRIEF DESCRIPTION OF THE DRAWINGS

FIG. 1 illustrates an example memory array of a memory device, according to one or more embodiments.
FIG. 2 illustrates an example configuration of the memory device, according to one or more embodiments.
FIG. 3 illustrates one or more operating method of the memory device, according to one or more embodiments.
FIG. 4 illustrates a read operation of the memory device, according to one or more embodiments.
FIG. 5 illustrates an example of a bit sequence using a resistance value combination in the memory device, according to one or more embodiments.
FIG. 6 illustrates an example read operation method according to one or more embodiments.
FIGS. 7A and 7B illustrate example read operations by a read circuit in a memory device according to one or more embodiments.
FIG. 8 illustrates an example method of setting a resistor value according to one or more embodiments.
FIGS. 9 and 10 illustrate example setting operations, by a memory device, a resistor value based on an error memory cell according to one or more embodiments.
FIGS. 11, and 12A and 12B illustrate example circuits of a write encoder referring to an error memory cell in a memory device according to one or more embodiments.
FIG. 13 illustrates an example method generating error information according to one or more embodiments.
FIGS. 14 through 16 illustrate examples of generating error information according to one or more embodiments.

Throughout the drawings and the detailed description, unless otherwise described or provided, the same drawing reference numerals may be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Throughout the specification, when a component or element is described as being "on", "connected to," "coupled to," or "joined to" another component, element, or layer it may be directly (e.g., in contact with the other component or element) "on", "connected to," "coupled to," or "joined to" the other component, element, or layer or there may reasonably be one or more other components, elements, layers intervening therebetween. When a component or element is described as being "directly on", "directly connected to," "directly coupled to," or "directly joined" to another component or element, there can be no other elements intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Due to manufacturing techniques and/or tolerances, variations of the shapes shown in the drawings may occur. Thus, the examples described herein are not limited to the specific shapes shown in the drawings, but include changes in shape that occur during manufacturing.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto.

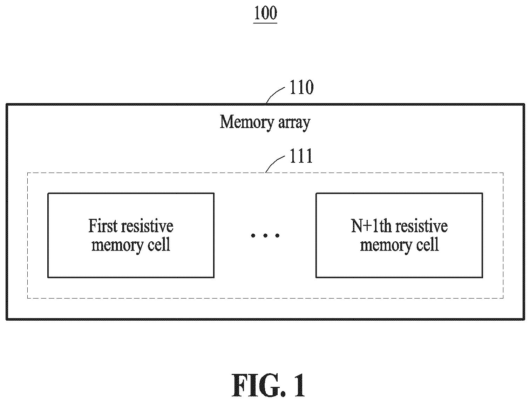

FIG. 1 illustrates an example memory device according to one or more embodiments.

Referring to FIG. 1, in a non-limiting example, a non-volatile memory device 100 may include a memory array 110. Herein, electronic devices, such as non-volatile memory device 100, are representative of one or more processors, or one or more processors and a memory storing instructions, configured to implement one or more, or any combination of, operations or methods described herein. The one or more processors may be respective special purpose hardware-based computers or other special-purpose hardware. The one or more processors may be configured to execute such instructions. The one or more memories may store the instructions, which when executed by the one or more processors configure the one or more processors to perform one or more, or any combination of operations of methods described herein.

The memory array 110 may include resistive memory cells. The resistive memory cells may be arranged along lines. For example, the resistive memory cells may be arranged along word lines and column lines. A word line may also be referred to as a row line.

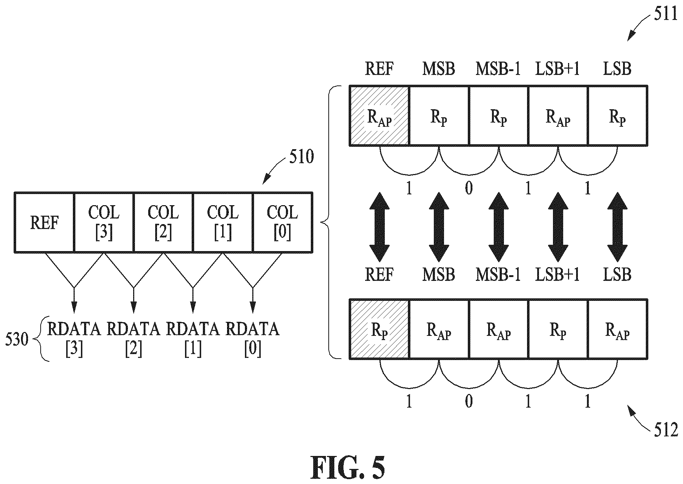

The memory array 110 may have N+1 resistive memory cells 111 for expressing a bit sequence of N bits for each word line. N may be greater than or equal to 2. The bit sequence may be a sequence of bit values. The bit sequence including N bit values ("N-bit sequence") is mainly described herein. A combination of N+1 resistance values (e.g., high/low) individually set for the N+1 resistive memory cells 111, corresponding to any one of the word lines, may correspond to (express/represent) an N-bit sequence. First to N+1-th resistive memory cells, as shown in FIG. 1, may be arranged along the same word line. The N+1 resistance values, to represent the desired N-bit sequence, may be determined based on a result of encoding the N-bit sequence. Encoding may be based on, for example, an exclusive OR (XOR) scheme. For example, a bit value may depend on the XOR of the values of two cells (e.g., if they are the same, '1', and otherwise '0'). A mapping relationship between a resistance value combination (e.g., the values in the N+1 cells) and a bit sequence (e.g., the N-bit sequence) is described below with reference to FIG. 5. The resistance value combination may be a combination of resistance values individually set for the respective N+1 resistive memory cells 111 of a word line corresponding to the resistance value combination; a resistance value combination may also be referred to as a resistance value sequence.

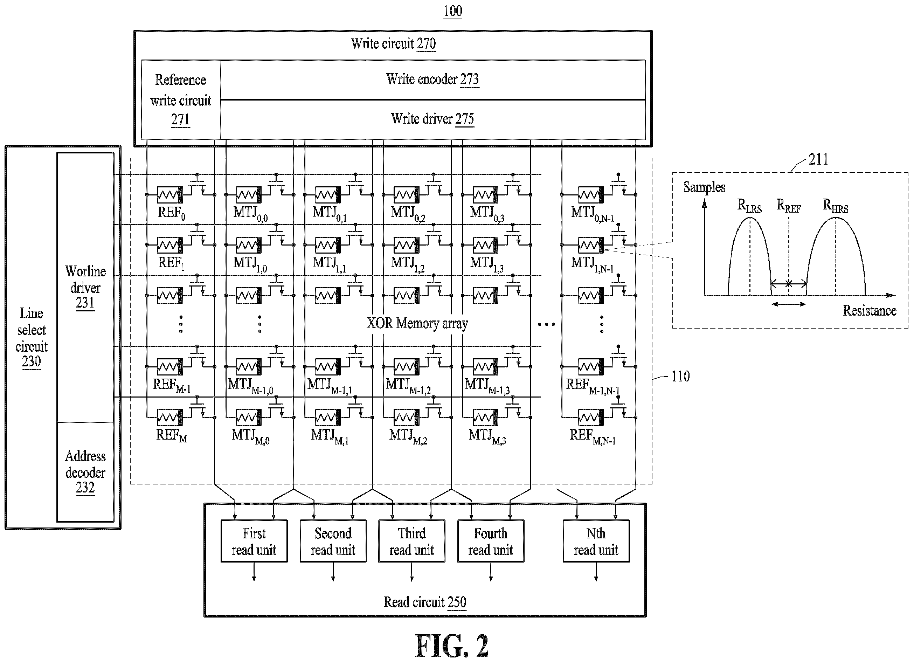

A resistive memory cell may include a resistive memory element. The resistive memory element (e.g., a magnetic tunnel junction (MTJ)) may be an element that has a set resistance value and may have one of multiple resistance values. The resistive memory element may have a resistance value of, for example, a first resistance value or a second resistance value. The first resistance value may be less than the second resistance value. The first resistance value may be a resistance value (e.g., R_{P}, in the MTJ example, referring to resistance-parallel) in a low resistance state (LRS), and the second resistance value may be a resistance value (e.g., R_{AP}, in the MTJ example, resistance-anti-parallel) in a high resistance state (HRS). As described below with reference to FIG. 2, the resistive memory element of the resistive memory cell may be, for example, magnetic random-access memory (MRAM).

According to an embodiment, resistance states (e.g., resistance values) of multiple resistive memory elements may configured/used to represent a single bit value. For example, a single bit value may be determined according to two resistance values of two adjacent resistive memory elements. For example, two adjacent same resistance-states may represent a first bit value (e.g., a bit value of 0), and two adjacent different resistance-states may represent a second bit value (e.g., a bit value of 1). For example, when a bit value of a specific bit position in a bit sequence is the first bit value, resistance values of adjacent memory elements corresponding to the specific bit position (among the N+1 resistive memory cells 111) may be the same. When a bit value of a specific bit position is the second bit value, resistance values of adjacent memory elements corresponding to the specific bit position (among the N+1 resistive memory cells 111) may be different.

An operating method (e.g., a memory encoding method) of the memory device 100 may involve encoding a bit value by using two adjacent resistive memory cells, i.e., mapping the bit value to appropriate resistance values of the adjacent resistive memory cells such that they can later be decoded to retrieve (reconstruct) the bit value therefrom. For example, the memory encoding method may set resistance values of two adjacent resistive memory cells to be the same when the bit value is a first value. The memory encoding method may set resistance values of two adjacent resistive memory cells to be different when the bit value is a second value. In the memory encoding method, N bit values may be encoded to resistance values of N+1 resistive memory cells that will store the N bit values (and the N+1 resistive memory cells' respective resistances set accordingly). The N+1 resistive memory cells may be connected to a shared word line (N may be greater than or equal to 2).

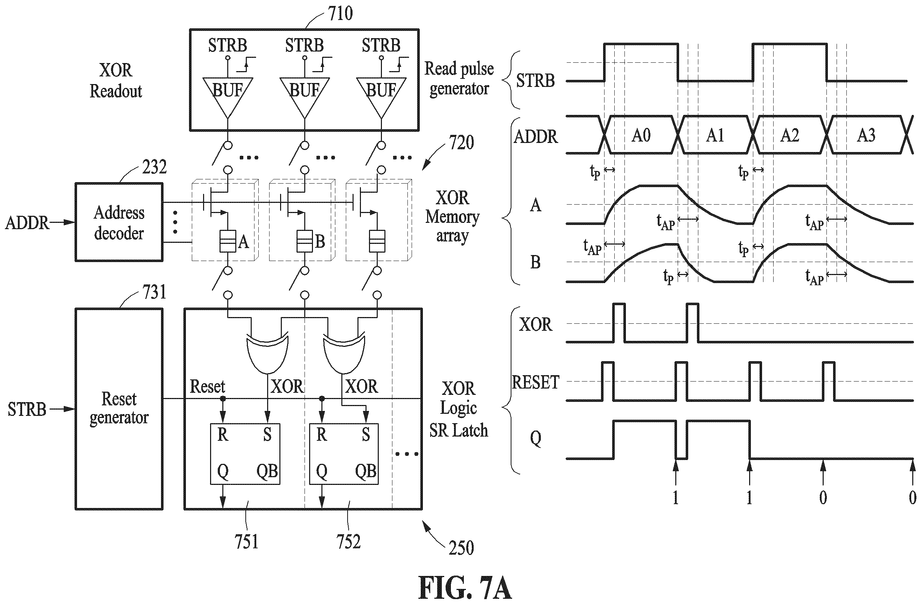

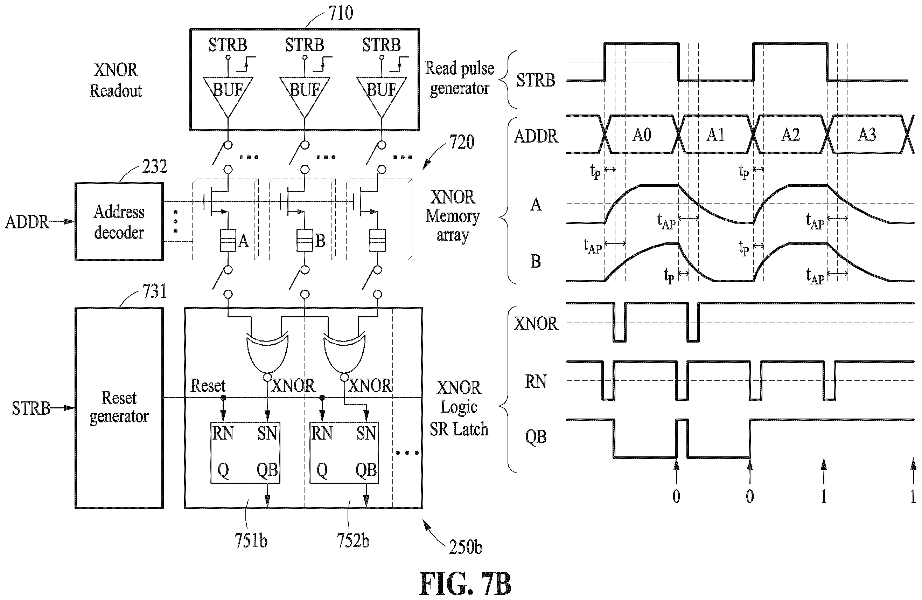

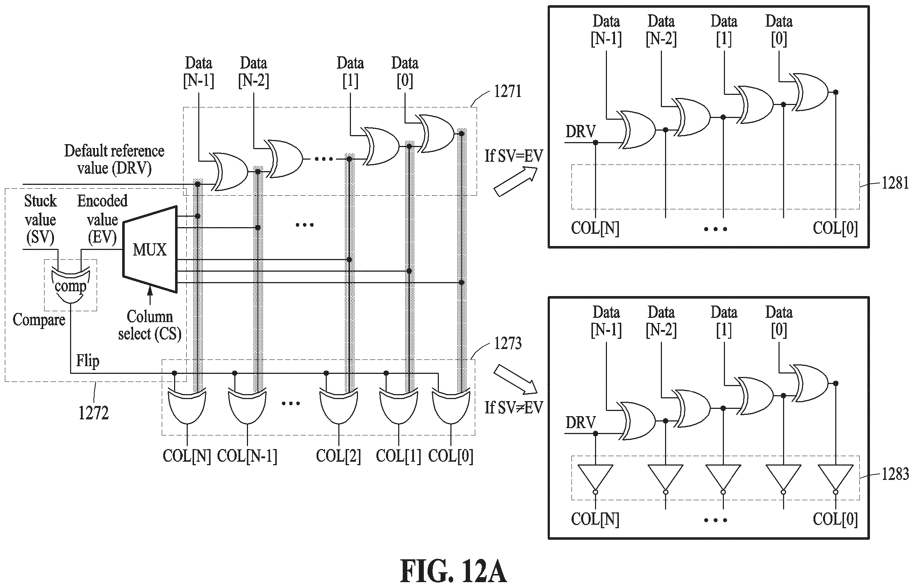

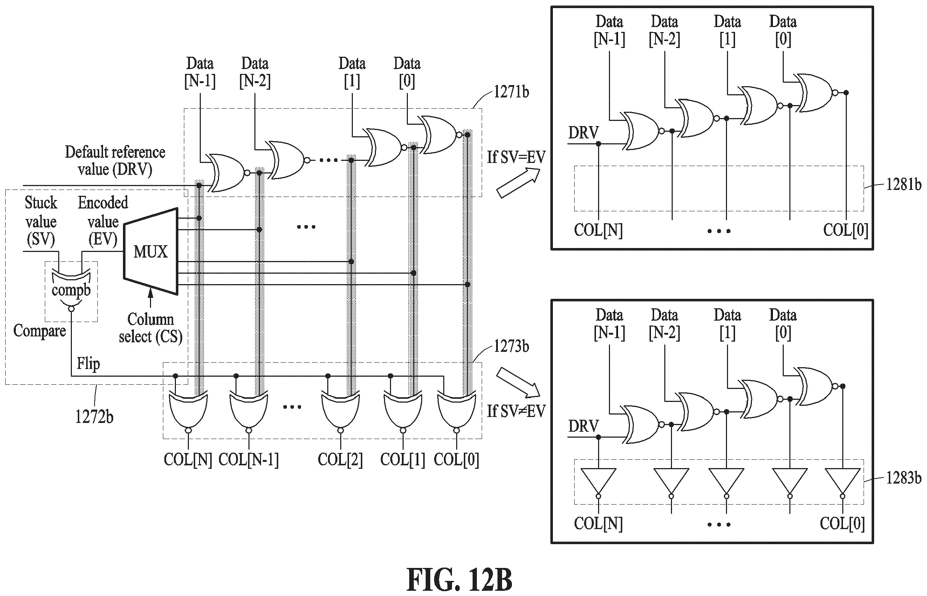

For reference, a non-limiting example where the first bit value is 0 and the second bit value is 1 is mainly described herein. The memory encoding method may be based on XOR, in which the first value is 0 and the second value is 1. Encoding that maps the bit value of 0 to two equal resistance values and maps the bit value of 1 to two differing resistance values, of two resistive memory elements, may be referred to as XOR encoding (here, "same" is functional - differences within a tolerance are expected). As described below, resistance values set through such mapping may be converted into bit values through XOR decoding operations. However, examples are not limited thereto. The memory encoding method may instead be based on exclusive negative OR (XNOR), in which the first value is 1 and the second value is 0. This may be referred to as XNOR encoding. XOR encoding-related operations are described below with reference to FIGS. 7A and 12A, and XNOR encoding-related operations are described below with reference to FIGS. 7B and 12B.

The memory device 100, in some embodiments, may have a memory macro structure having resistive memory cells to which set to resistance values obtained by encoding a bit sequence based on XOR encoding. The memory macro structure of the memory device 100 may have a decreased area overhead and an increased readout margin relative to prior resistive memory devices. Accordingly, the memory device 100 may use less power than prior devices to perform a read process.

FIG. 2 illustrates an example configuration of the memory device 100, according to one or more embodiments.

The memory device 100 may include the memory array 110, a line select circuit 230, a readout circuit 250, and a write circuit 270.

As described above, the memory array 110 may include N+1 resistive memory cells for expressing/representing an N-bit sequence for each line (e.g., word line). In the example illustrated in FIG. 2, the memory array 110 may have M+1 word lines and N+1 column lines. The N+1 column lines may include N data column lines and one reference column line (left side). Here, M may be greater than or equal to 1, and N may be greater than or equal to 2. The memory array 110 may include a total of (M+1)×(N+1) resistive memory cells.

In the example illustrated in FIG. 2, a resistive memory cell may have 1T 1R (e.g., a one transistor/one resistor) structure, i.e., one transistor and one resistive element. A cell's one transistor may operate as a switching element that to control access to the cell's corresponding resistive element (among the resistive elements arranged along lines). The switching element (e.g., the transistor) of the resistive memory cell may be turned on by a word line driver 231 as described below. Referring to FIG. 2, the resistive memory cell may include an MRAM element as a resistive memory element.

The MRAM element may have, for example, a magnetic tunnel junction (MTJ) element. Referring to FIG. 2, MTJ_{i,j} is the MTJ element of the i-th word line (among word lines) and of the j-th data column line (among data column lines). REFᵢ is an MTJ element of the i-th word line and of a reference line (e.g., the reference column line). i may be greater than or equal to 0 and less than or equal to M, and j may be greater than or equal to 0 and less than or equal to N-1.

An MTJ element may be a memory element whose resistance value changes depending on the spin state of internal electrons. For example, the MRAM element may have a resistance value corresponding to either of an HRS R_{AP} and an LRS R_{P}, depending on the setting/implementation. The MRAM element may be non-volatile due to preservation of the spin state of the internal electrons even when the power voltage is removed. The size and leakage current of the MRAM element may be small. The MRAM element is mainly described as an example of a resistive memory element herein, but examples are not limited thereto. The resistive memory element may be, for example, a ferroelectric RAM (FRAM) element, a phase change memory (PCM) element, a 3D XPoint element, a spin-transfer torque (STT)-MRAM element, a nano-RAM (NRAM) element, a resistive RAM (ReRAM) element, a conductive bridge RAM (CBRAM), or any other suitable to of resistive memory element.

The line select circuit 230 may select at least one word line, from among the multiple word lines, for a read operation or a write operation. The line select circuit 230 may include an address decoder 232 and the word line driver 231.

The address decoder 232 may identify, from among the word lines, a word line corresponding to a given address. For example, a memory device may receive an access request for a memory (e.g., the memory array 110) from an external device (e.g., a host). The access request may be a request for access for a read operation or a write operation and may include information (e.g., a memory address) indicating a memory position intended to be accessed in the memory (e.g., the memory array 110). By decoding the memory address, the address decoder 232 may generate information indicating a word line corresponding to the requested memory position from among the word lines.

The word line driver 231 may activate a word line corresponding to the access request. For example, the word line driver 231 may enable a signal (e.g., a word line selection signal) to a word line selected from among the word lines. The word line driver 231 may enable an activation signal to a word line indicated by a result of the address decoder 232 decoding the access request. Switching elements (e.g., transistors) of respective resistive memory cells connected to the selected word line may be turned on by the signal enabled to the selected word line. Resistive memory elements arranged on the selected word line may be individually connected to respective column lines. The memory device may set (e.g., write) a resistance value for the resistive memory elements of the activated word line or may read a previously stored resistance value. One resistive element may store data.

The readout circuit 250 may read data (e.g., the N-bit sequence) recorded in the N+1 resistive memory cells of the memory array 110. For example, the readout circuit 250 may generate a bit-read signal based on the result of XORs between resistance values set for the N+1 resistive memory cells arranged along a word line selected for reading. As described below with reference to FIG. 5, resistance value combinations (e.g., of N+1 values) may be mapped to bit sequences (e.g. N-bit sequences) based on XOR encoding. The readout circuit 250 may include N readout units (e.g., a first readout unit to an N-th readout unit) of the respective columns that are configured to individually generate N respective bit-read signals. Since each readout unit includes its own logic element and/or a logic circuit (e.g., an XOR circuit), a readout unit may have a relatively simplified structure and reduced power consumption. In addition, since a comparison (e.g., XOR) between resistive memory cells along adj acent column lines is performed, a readout margin may be secured, and a further efficient read operation may be enabled.

The write circuit 270 may write resistance values (values according to a corresponding N-bit sequence) to resistive memory cells of the memory array 110. If a memory access request is a request for writing, the memory access request may include a memory address and a value (e.g., a bit sequence) to be recorded in the memory address. For resistive memory cells of a word line activated for the memory access request, the write circuit 270 may set resistance values corresponding to a result of an XOR encoding of the bit sequence of the memory access request. The write circuit 270 may include a reference write circuit 271, a write encoder 273, and a write driver 275.

The reference write circuit 271 may set resistance values of resistive memory elements arranged along the reference column line. For example, the reference write circuit 271 may set a resistance value determined according to XOR encoding for a resistive memory element corresponding to the reference column line in a selected word line. As described below, the reference resistance value of a word line may indicate how XOR decoding is to be performed for the resistive memory elements of that word line.

Although FIG. 2 illustrates the reference write circuit 271 separately from the write encoder 273 and the write driver 275, examples are not limited thereto. The configuration and/or function of the reference write circuit 271 may be integrated into the write encoder 273 and/or the write driver 275. The division of functionality between components is arbitrary and not significant.

The write encoder 273 may generate N+1 write signals individually indicating resistance values to be set for the N+1 resistive memory cells of the selected row/word line, which may be based on a reference signal and N bit signals (the data to be stored) individually indicating bit values of the N-bit sequence. The reference signal may be a signal that indicates a bit value corresponding to a resistance value (e.g., a reference resistance value) that is set for a resistive memory element arranged in the reference column line in the corresponding word line. The N bit signals may be signals that individually indicate bit values corresponding to bit positions of the N-bit sequence. Each of the N+1 write signals may indicate a resistance value set for a corresponding resistive memory cell in the word line.

To summarize, the write driver 275 may translate the binary N+1 write signals into respectively corresponding voltages/currents to be written. More specifically, the write driver 275 may set resistance values, which are to be written to resistive memory cells on a word line selected for writing, according to a result of XOR-encoding of the to-be-written bit sequence. Each of the N+1 write signals may indicate a resistance value to be set for a respectively corresponding resistive memory element of a specific position among the N+1 resistive memory elements in the selected word line. The write driver 275 may set a resistance value indicated by a specific write signal for a corresponding resistive memory cell. The write driver 275 may set resistance values of the N+1 resistance memory cells by using the N+1 write signals. For example, if a bit value of the specific write signal is 0, the write driver 275 may set a resistance value (e.g., R_{P}) of a first resistance state (e.g., the LRS) for a corresponding resistive memory cell. For another example, if the bit value of the specific write signal is 1, the write driver 275 may set a resistance value (e.g., R_{AP}) of a second resistance state (e.g., the HRS) for a corresponding resistive memory cell. The write driver 275 may set a resistance value determined based on XOR encoding for a corresponding resistive memory element by enabling a set signal (e.g., a voltage and/or a current) corresponding to a corresponding write signal to each resistive memory element of the activated word line.

According to some embodiments, in the memory device, two resistance values set for two respective adjacent (in the row direction) resistive memory cells arranged along a word line together express/represent one bit value. The memory device may read a bit value resistive memory element regardless of its resistance offset corresponding to its position in the memory array 110 (e.g., caused by wiring resistance, which can vary among the resistive memory elements due to their varying circuit locations and corresponding wire lengths).

In some embodiments, a reference resistance used to read a resistance value of a specific resistive memory cell may be a resistance value of a resistive memory cell in the row of the specific resistive memory cell. As compared to other technologies, since a reference threshold resistance R_{REF} of a reference row or a reference column is compared to a resistance (e.g., R_{LRS} or R_{HRS}) of each resistive memory cell, there is a problem that the resistance of each resistive memory cell depends on its row position and/or its column position. On the other hand, some embodiments of the memory device described herein may avoid this problem since the resistance value of each resistive memory cell is compared to a resistance value of an adjacent (in the row direction, e.g., adjacent to the right) resistive memory cell, a read offset (location-dependent resistance component) may be suppressed even in different column positions.

The memory device may read bit values according to a combination of resistance values (i.e., according to the resistance values of each resistive memory element) by providing a further increased readout margin despite a variance of a resistance value of a resistive memory element (e.g., an MTJ). In comparing adjacent resistive memory elements, since the resistive memory elements are implemented with the same material, a process, voltage, and temperature (PVT) variance 211 moves in the same direction for each element, and a further robust read feature may be provided.

In addition, other technologies the LRS may be a state having a resistance lower than the reference resistance, and the HRS may be a state having a resistance higher than the reference resistance. On the contrary, in some embodiments described herein, the LRS may merely be a state lower than the HRS, and the HRS may be a state higher than the LRS. Accordingly, in the memory device according to some embodiments, a readout margin considered in order to identify a resistance state may substantially increase compared to prior technologies. For example, the readout margin may increase by about two times. This is because an adjacent MTJ element (in the row direction, e.g., to the right) having a symmetrical layout may function as a kind of reference. Accordingly, since the memory device secures a relatively large noise margin, the memory device may provide further robustness of readout results against PVT variance 211.

Two MTJs may be a reference for each other and may be implemented in a small area. As described above, the memory array 110 may be implemented through the N+1 resistive memory cells (e.g., the N+1 resistive memory elements) as the N-bit sequence. Accordingly, an area overhead for providing the aforementioned possible benefits is minute since only one column line is added in an entire macro structure.

Memory devices according to some embodiments may be non-volatile yet may effectively decrease power consumption and may block leakage current by retaining data even when power is off. The memory devices may be used in various hardware including a neuromorphic processor, a mobile device, or an edge device. The memory device may provide a decreased power consumption and a decreased area in a read operation and a write operation.

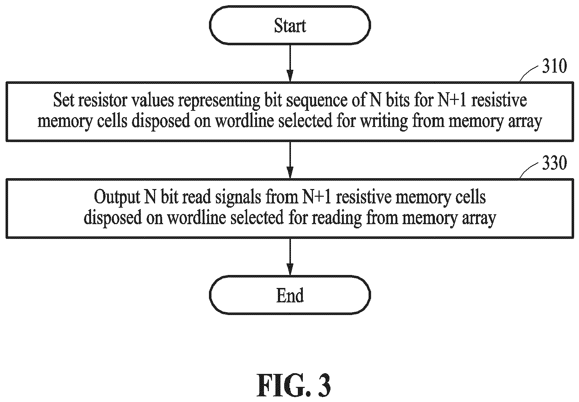

FIG. 3 illustrates an operating method of the memory device, according to one or more embodiments.

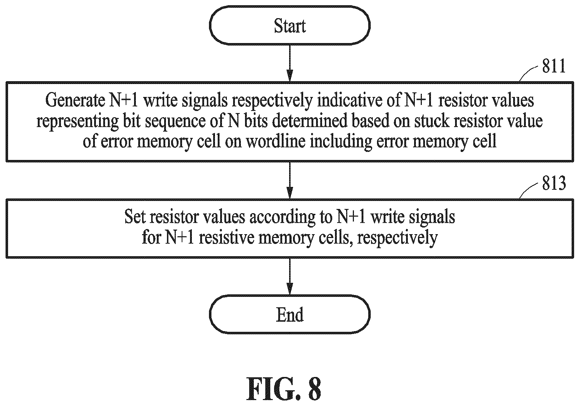

In operation 310, a non-volatile memory device may set resistance values for expressing an N-bit sequence for N+1 respective resistive memory cells arranged in a word line selected for writing in a memory array. Here, N may be greater than or equal to 2. For example, a word line driver of the memory device may select a word line corresponding to a memory write request. A write circuit may set resistance values determined based on XOR encoding from a bit sequence corresponding to the memory write request for resistive memory cells arranged along a selected word line. When a bit value of a bit position in the bit sequence is a first bit value, the memory device may set the same resistance value for adjacent memory element corresponding to the bit position. When the bit value of the bit position is a second bit value, the memory device may set a different resistance value for the adjacent memory element corresponding to the bit position. An example of this kind of write operation of the memory device will be described in greater detail below with reference to FIGS. 8 through 16.

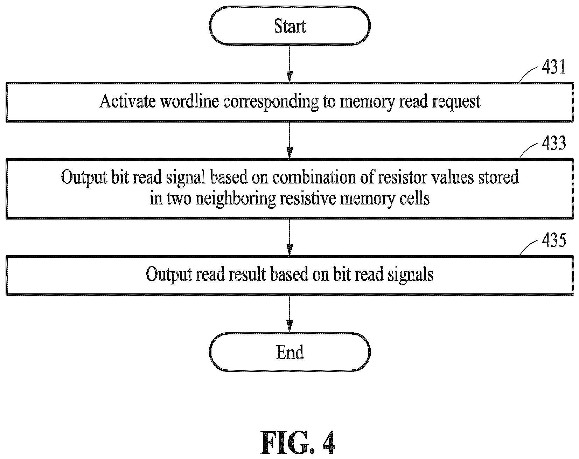

In operation 330, the non-volatile memory device may output N bit-read signals from N+1 resistive memory cells arranged in a word line selected for reading in the memory array. For example, the word line driver of the memory device may select a word line corresponding to a memory read request. A readout circuit may determine bit-read signals based on an XOR operation from resistance values set for resistive memory cells of a word line corresponding to the memory read request. The read operation of the memory device is described below with reference to FIGS. 4 to 7A and 7B.

FIG. 4 illustrates a read operation of the memory device, according to one or more embodiments. FIG. 5 illustrates an example of a bit sequence using a resistance value combination in the memory device, according to one or more embodiments.

Referring to FIG. 4, in a non-limiting example, in operation 431, a memory device (e.g., the memory device 100) may activate (or enable) a wordline corresponding to a memory read request. For example, the memory device may identify the wordline indicated by a memory address of the memory read request. The memory device may activate resistive memory cells by connecting the resistive memory elements of the identified wordline to their respective column lines.

In operation 433, the memory device may output a bit-read signal according to a combination of resistance values stored in two adjacent (in the same row) resistive memory cells. The memory device may determine a bit-read signal indicating a bit value for each of the two adjacent resistive memory cells in resistive memory elements arranged along a word line. The memory device may determine a bit value corresponding to resistance values of the two adjacent resistive memory cells based on mapping according to XOR encoding. The mapping according to XOR encoding is described below through Tables 1 and 2. Table 1 is a truth table of an XOR element provided as a reference.

**Table 1:**

| A | B | Q |
|---|---|---|
| 0 | 0 | 0 |
| 0 | 1 | 1 |
| 1 | 0 | 1 |
| 1 | 1 | 0 |

As shown in Table 1, XOR may have an output Q of 0 when inputs A and B (A, B) are the same, and an output Q of 1 when the inputs A and B (A, B) are different. A resistor value (e.g., R_{P}) of a first resistance state (e.g., a low resistance state, LRS) itself or a signal (e.g., a voltage signal or current signal) corresponding to the resistor value of the first resistance state may represent a first logic value (e.g., L or 0). A resistor value (e.g., R_{AP}) of a second resistance state (e.g., a high resistance state, HRS) itself or a signal (e.g., a voltage signal or current signal) corresponding to the resistor value of the second resistance state may represent a second logic value (e.g., H or 1). Referring to the truth table in Table 1 above, two inputs A and B to an XOR operation may be logic values corresponding to resistor values set for neighboring resistive memory elements, and an output Q may be a bit value. Therefore, the mapping between each bit value and a resistor value combination according to XOR encoding may be represented as shown in Table 2 below.

**Table 2:**

| Data value | Resistor value combination based on XOR encoding or XOR decoding |
|---|---|
| 0 | (R_{AP}, R_{AP}) or (R_{P}, R_{P}) |
| 1 | (R_{AP}, R_{P}) or (R_{P}, R_{AP}) |

As shown in Table 2 above, a bit value of 0 may be written and read as (R_{AP}, R_{AP}) or (R_{P}, R_{P}) indicating that a state where two resistive memory cells have the same resistor value. A bit value of 1 may be written and as (R_{AP}, R_{P}) or (R_{P}, R_{AP}) indicating a state where the two resistive memory cells have different resistor values. A result of the XOR operation between logic values corresponding to resistor values stored in two resistive memory cells may be a bit value at a corresponding bit position. Thus, a result of XOR encoding of a corresponding bit value may be the resistor values stored in the two neighboring resistive memory cells corresponding to the bit position.

In operation 435, the memory device may output a readout result based on bit-read signals. As described above, resistive memory cells arranged along each word line of a memory array may have resistance values corresponding to a result of an XOR-based encoding of a bit sequence. According to some embodiments, the memory device may determine a bit sequence to be read-out by decoding a resistance value combination based on an XOR operation. For example, the memory device may generate the bit-read signals by collectively performing an operation according to operation 433 for each pair of adjacent resistive memory cells (in a word/row). For reference, there are N adjacent pairs when there are N+1 resistive memory cells, and an operation according to operation 433 may be simultaneously and/or parallelly performed on the N adjacent pairs. The memory device may generate, as a readout result, an N-bit sequence corresponding to the resistance value combination (e.g., a resistance value sequence) by combining (joining) bit values individually indicated by the generated bit-read signals.

To aid understanding XOR-based decoding of N+1 resistance values to N bit values, consider example 510 shown in FIG. 5. Example 510 involves expressing a 4-bit sequence 530 (4 data bits) through 4 data column lines COL[3:0] and a reference column line REF (5 resistance values). The 4-bit sequence 530 is denoted by RDATA[3:0], and the data of the 4-bit sequence 530 may be "1011", as an example. A first resistance value combination 511 (upper right) is a first way of expressing the example 4-bit sequence 530 ("1011"), and the second resistance value combination 512 (lower right) is a second way of expressing the same 4-bit sequence 530 ("1011").

In the case of the first resistance value combination 511, in the 4-bit sequence 530, if the reference resistance value (REF) is R_{AP}, 1, which is RDATA[3] (e.g., a most significant bit (MSB)), is expressed by (R_{AP}, R_{P}) (the XOR of REF and MSB). And, 0, which is RDATA[2] (e.g., MSB-1), is expressed by (R_{P}, R_{P}) (the XOR of MSB and MSB-1). Likewise, RDATA[1] and RDATA[0] are respectively expressed by (R_{P}, R_{AP}) (the XOR of MSB-1 and LSB+1) and (R_{AP}, R_{P}) (the XOR of LSB+1 and LSB). Accordingly, when combining these resistance values, the first resistance value combination 511 may be (R_{AP}, R_{P}, R_{P}, R_{AP}, R_{P}), whose the first resistance value is a reference resistance value having resistance value R_{AP}.

On the other hand, in the case of second resistance value combination 512, if the reference resistance value is Rp, a second resistance value combination 512 may be (R_{P}, R_{AP}, R_{AP}, R_{P}, R_{AP}). The reference resistance value may be a resistance value that is a reference for a resistance value combination (or a resistance value sequence) and may be, for example, the very first resistance value. The memory device may select a resistance value combination by determining a value of a write signal indicating the reference resistance value. For example, the memory device may select the first resistance value combination 511 by determining the value of the write signal indicating the reference resistance value to 1 (corresponding to R_{AP}). The memory device may select the second resistance value combination 512 by determining the value of the write signal indicating the reference resistance value to 0 (corresponding to R_{P}).

As described in the example above, according to XOR encoding, two resistance value combinations may always express a one bit sequence. For example, the memory device may set (e.g., write) one resistance value combination among available resistance value combinations expressing the bit sequence for the N+1 resistive memory cells of a word line selected for writing. As illustrated in FIG. 5, the resistance value combinations expressing one bit sequence may be in a complementary relationship due to XOR encoding. In other words, the resistance values of any one of the resistance value combinations may have a logic value opposite to the resistance values of the other resistance value combination in a corresponding column line. As described above, since two resistance value combinations correspond to the same bit sequence, the memory device may output the same bit sequence as a result of reading the two resistance value combinations.

Although only one example of a single 4-bit sequence is shown in FIG. 5, Tables 3 and 4 below may illustrate two resistor value combinations available for all 4-bit sequences. In Tables 3 and 4 below, COL[4] may be a reference column line and COL[3:0] may be data column lines. Table 3 provides resistor value combinations respectively corresponding to 4-bit sequences when a low resistor value (R_{P}) is set as the reference resistor value for resistive memory cells of the reference column line COL[4]. Table 4 provides resistor value combinations respectively corresponding to 4-bit sequences when a high resistor value (R_{AP}) is set as the reference resistor value for the resistive memory cells of the reference column line COL[4].

**Table 3:**

| Original Data | | | | Resistor Value | | | | |
|---|---|---|---|---|---|---|---|---|
| DATA[3] | DATA[2] | DATA[1] | DATA[0] | COL[4] | COL[3] | COL[2] | COL[1] | COL[0] |
| 0 | 0 | 0 | 0 | R_{P} | R_{P} | R_{P} | R_{P} | R_{P} |
| 0 | 0 | 0 | 1 | R_{P} | R_{P} | R_{P} | R_{P} | R_{AP} |
| 0 | 0 | 1 | 0 | R_{P} | R_{P} | R_{P} | R_{AP} | R_{AP} |
| 0 | 0 | 1 | 1 | R_{P} | R_{P} | R_{P} | R_{AP} | R_{P} |
| 0 | 1 | 0 | 0 | R_{P} | R_{P} | R_{AP} | R_{AP} | R_{AP} |
| 0 | 1 | 0 | 1 | R_{P} | R_{P} | R_{AP} | R_{AP} | R_{P} |
| 0 | 1 | 0 | 1 | R_{P} | R_{P} | R_{AP} | R_{AP} | R_{P} |
| 0 | 1 | 1 | 0 | R_{P} | R_{P} | R_{AP} | R_{P} | R_{P} |
| 0 | 1 | 1 | 1 | R_{P} | R_{P} | R_{AP} | R_{P} | R_{AP} |
| 1 | 0 | 0 | 0 | R_{P} | R_{AP} | R_{AP} | R_{AP} | R_{AP} |
| 1 | 0 | 0 | 1 | R_{P} | R_{AP} | R_{AP} | R_{AP} | R_{P} |
| 1 | 0 | 1 | 0 | R_{P} | R_{AP} | R_{AP} | R_{P} | R_{P} |
| 1 | 0 | 1 | 1 | R_{P} | R_{AP} | R_{AP} | R_{P} | R_{AP} |
| 1 | 1 | 0 | 0 | R_{P} | R_{AP} | R_{P} | R_{P} | R_{P} |
| 1 | 1 | 0 | 1 | R_{P} | R_{AP} | R_{P} | R_{P} | R_{AP} |
| 1 | 1 | 1 | 0 | R_{P} | R_{AP} | R_{P} | R_{AP} | R_{AP} |
| 1 | 1 | 1 | 1 | R_{P} | R_{AP} | R_{P} | R_{AP} | R_{P} |

**Table 4:**

| Original Data | | | | Resistor Value | | | | |
|---|---|---|---|---|---|---|---|---|
| DATA[3] | DATA[2] | DATA[1] | DATA[0] | COL[4] | COL[3] | COL[2] | COL[1] | COL[0] |
| 0 | 0 | 0 | 0 | R_{AP} | R_{AP} | R_{AP} | R_{AP} | R_{AP} |
| 0 | 0 | 0 | 1 | R_{AP} | R_{AP} | R_{AP} | R_{AP} | R_{P} |
| 0 | 0 | 1 | 0 | R_{AP} | R_{AP} | R_{AP} | R_{P} | R_{P} |
| 0 | 0 | 1 | 1 | R_{AP} | R_{AP} | R_{AP} | R_{P} | R_{AP} |
| 0 | 1 | 0 | 0 | R_{AP} | R_{AP} | R_{P} | R_{P} | R_{P} |
| 0 | 1 | 0 | 1 | R_{AP} | R_{AP} | R_{P} | R_{P} | R_{AP} |
| 0 | 1 | 0 | 1 | R_{AP} | R_{AP} | R_{P} | R_{P} | R_{AP} |
| 0 | 1 | 1 | 0 | R_{AP} | R_{AP} | R_{P} | R_{AP} | R_{AP} |
| 0 | 1 | 1 | 1 | R_{AP} | R_{AP} | R_{P} | R_{AP} | R_{P} |
| 1 | 0 | 0 | 0 | R_{AP} | R_{P} | R_{P} | R_{P} | R_{P} |
| 1 | 0 | 0 | 1 | R_{AP} | R_{P} | R_{P} | R_{P} | R_{AP} |
| 1 | 0 | 1 | 0 | R_{AP} | R_{P} | R_{P} | R_{AP} | R_{AP} |
| 1 | 0 | 1 | 1 | R_{AP} | R_{P} | R_{P} | R_{AP} | R_{P} |
| 1 | 1 | 0 | 0 | R_{AP} | R_{P} | R_{AP} | R_{AP} | R_{AP} |
| 1 | 1 | 0 | 1 | R_{AP} | R_{P} | R_{AP} | R_{AP} | R_{P} |
| 1 | 1 | 1 | 0 | R_{AP} | R_{P} | R_{AP} | R_{P} | R_{P} |
| 1 | 1 | 1 | 1 | R_{AP} | R_{P} | R_{AP} | R_{P} | R_{AP} |

The description of a 4-bit bit sequence is provided above, but two resistance value combinations are also available for an arbitrary N- bit sequence greater than or equal to 4 bits. Table 5 below shows resistance value combinations to which 8b-bit bit sequence 8'b10010101 is mapped.

**Table 5:**

| Bit sequence | 8'b10010101 |
|---|---|
| 1 REF + 8 MTJ used | R_{P}R_{AP}R_{AP}R_{AP}R_{P}R_{P}R_{AP}R_{AP}R_{P} or R_{AP}R_{P}R_{P}R_{P}R_{AP}R_{AP}R_{P}R_{P}R_{AP} |

Thus, even when the number N of bits forming a bit sequence increases, the memory device may represent N bits (e.g., 8-bit) with N+1 (e.g., 9) resistive memory elements.

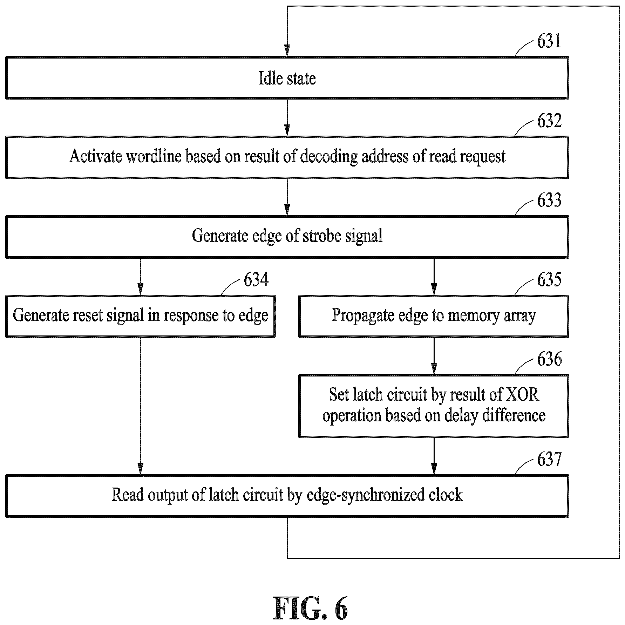

FIG. 6 illustrates an example read operation method according to one or more embodiments. Referring to FIG. 6, in a non-limiting example, in operation 631, a memory device (e.g., the memory device 100) may be in an idle state waiting for a memory access request. In response to a memory read request being received, the memory device may initiate operations to read a memory.

In operation 632, the memory device (e.g., the memory device 100) may activate (or enable) a wordline 720 based on decoding an address of the read request.

FIGS. 7A and 7B illustrate example read operations by a read circuit in a memory device according to one or more embodiments. Referring to FIG. 7A, in a non-limiting example, an address decoder 232 may receive an address ADDR of a memory read request. The address decoder 232 may provide information indicating the wordline 720 corresponding to a result of decoding the address ADDR. For example, a wordline driver may activate (or enable) the wordline 720 corresponding to the address ADDR. By applying a signal of 1 along the wordline 720 selected from a memory array, the wordline driver may allow a read pulse to be transferred to resistive memory elements located on the selected wordline 720.

Referring to FIG. 6, in operation 633, the memory device (e.g., the memory device 100) may generate an edge of a strobe signal STRB. For example, a strobe signal generation circuit (not shown) of the memory device may generate the strobe signal STRB. The strobe signal STRB may be provided to a read pulse generator 710 and a reset generator 731 illustrated in FIG. 7A. Both a rising edge and a falling edge of the strobe signal STRB may be used.

In operation 634, the memory device (e.g., the memory device 100) may generate a reset signal in response to the edge. For example, referring to FIG. 7A, the reset generator 731 may generate the reset signal in response to the strobe signal STRB. The reset generator 731 may detect each rising edge and each falling edge of the strobe signal STRB. The reset generator 731 may transfer a pulse (e.g., a short pulse) to reset ports of SR latches of a read circuit 250 for each rising edge and falling edge of the strobe signal STRB. Thus, at each edge of the strobe signal STRB, data stored at a Q node of an SR latch may be initialized to zero (0).

Referring to FIG. 6, in operation 635, the memory device may propagate the edge to the memory array. Referring to FIG. 7A, the read pulse generator 710 of the memory device may include a buffer connected to each column line (e.g., bitline) and may supply a strobe signal STRB to a corresponding column line through the buffer to drive the bitline.

Referring to FIG. 6, in operation 636, the memory device (e.g., the memory device 100) may set a latch circuit as a result of an XOR operation based on a delay difference. In an example, the read circuit 250 may include an XOR element connected to two neighboring resistive memory cells among N+1 resistive memory cells. Referring to FIG. 7A, a first read unit 751 and a second read unit 752 may each include an XOR element. In the first read unit 751, the XOR element may output a result of comparing a resistor value of a first resistive memory element A and a resistor value of a second resistive memory element B. For example, the first read unit 751 may output a value of 0 when the resistor value of the first resistive memory element A and the resistor value of the second resistive memory element B are the same, and a value of 1 when the resistor values are different.

In an example, a voltage may be provided to an input end of an XOR element by power driven to a bitline. A time for which the voltage is charged or discharged may vary depending on a resistor value set for a resistive memory cell and a parasitic capacitance formed along the bitline. The XOR element may output a result (e.g., 0 if equal, 1 if different) of a comparison between resistor values set for two resistive memory elements through a delay (e.g., a charge delay or discharge delay) that varies according to a resistor value set for each resistive memory element, as described above. For example, the read circuit 250 may provide an output, as bit values, for two neighboring resistive memory cells based on a result of a comparison between delays occurring in the two neighboring resistive memory cells, depending on resistor values set for the two neighboring resistive memory cells and the parasitic capacitance. Each XOR circuit of the read circuit 250 may output an XOR output as "1" when a difference in delay exceeds a threshold, and may output the XOR output as "0" when the difference in delay is less than or equal to the threshold.

For example, resistor values stored in a first resistive memory element A and a second resistive memory element B of a first address A0, among a plurality of wordlines, may be (R_{P}, R_{AP}). A first time t_{P} may be used until a voltage of a node to which the first resistive memory element A with a first resistor value R_{P} being set and an XOR element are connected reaches a threshold voltage. A second time t_{AP} may be used until a voltage of a node to which the second resistive memory element B with a second resistor value R_{AP} being set and the XOR element are connected reaches the threshold voltage. The first time t_{P} may be shorter than the second time t_{AP}. Therefore, a delay corresponding to (t_{P}, t_{AP}) may occur from a rising edge of a strobe signal STRB until the voltages of the resistive memory elements A and B reach the threshold voltage, respectively. Therefore, the voltages at two input ends of the XOR element may be different for a delay difference, i.e., t_{AP} - t_{P}. The XOR element may generate an output pulse corresponding to a "1" (or a logic value H) during the delay difference of t_{AP} - t_{P}. This output pulse may be transferred to a set port of an SR latch in a corresponding read unit. A Q node of the SR latch may output a signal corresponding to "1" (or the logic value H).

In an example, resistor values stored in a first resistive memory element A and a second resistive memory element B of a second address A1. among a plurality of wordlines, may be (R_{AP}, R_{P}). Similarly, a delay corresponding to (t_{AP}, t_{P}) may occur from a falling edge of a strobe signal STRB until voltages of the resistive memory elements A and B reach the threshold voltage, respectively. For reference, a charging time of a voltage may be considered in the rising edge, and a discharging time of the voltage may be considered in the falling edge. The XOR element may generate an output pulse corresponding to a logic value H during a delay difference t_{AP} - t_{P}. A Q node of an SR latch may output a signal corresponding to "1" (or the logic value H).

In an example, resistor values stored in a first resistive memory element A and a second resistive memory element B of a third address A2 may be (R_{P}, R_{P}). In this case, the same delay (e.g., t_{P}) may occur from an edge of a strobe signal STRB until a voltage of each resistive memory element reaches the threshold voltage. Thus, the XOR element may provide a signal corresponding to "0" (or a logic value L). Thus, the SR latch may maintain a value of 0 (e.g., a signal corresponding to the logic value L) initialized by a reset signal. At a fourth address A3, an output of the SR latch may also remain at 0 because the delay is the same as t_{AP}.

For reference, although only an example including the first resistive memory element A and the second resistive memory element B in the wordline 720 corresponding to the first address A0 has been described above with reference to FIG. 7A, the same or similar description may also be applied to N+1 resistive memory cells including a resistive memory element of a reference column line and resistive memory elements of data column lines.

In addition, resistor values of resistive memory elements may not be ideal and are may not be perfectly the same, and thus, there may thus be an error. Therefore, even when the same resistor value is set, there may be a difference in delay. Therefore, an XOR element (or an XOR circuit) may be designed to output a pulse signal corresponding to a "1" (or a logic value H) only when a difference in delay at two input ends exceeds a threshold value. The XOR element may also be designed such that the threshold is variable and adjustable.

Although FIG. 7A illustrates an example of reading using a delay difference, examples are not limited thereto. The memory device may also apply a current to resistive memory elements and output a result of sensing a voltage difference. The memory device may also apply a voltage to resistive memory elements and output a result of sensing a current difference. The memory device may be implemented in various structures that may compare resistor values set for two neighboring resistive memory elements.

Referring to FIG. 6, in operation 637, the memory device (e.g., the memory device 100) may read an output of the latch circuit with an edge-synchronized clock. For example, the memory device may read a bit value set for the Q node of the SR latch with a clock synchronized with a rising edge and a falling edge of a strobe signal STRB through an input-output logic (IO logic). As described above with reference to FIG. 7A, bit values for resistive memory cells located on the same wordline 720 may be read all together at once.

Once the memory device has completed outputting bit read signals, it may return to operation 631, in FIG. 6, and wait for a next memory access request in the idle state.

Although XOR encoding has been mainly described above with reference to FIG. 7A, examples are not limited thereto. The memory device may also have resistor values set based on exclusive-NOR (XNOR) encoding instead of the XOR encoding. Referring to FIG. 7B, in a non-limiting example, an operation of reading resistor values based on XNOR encoding is illustrated, and the XNOR encoding will be described in greater detail below with reference to FIG. 12B.

In an example, a memory device (e.g., the memory device 100) may read a bit sequence from resistor values set based on XNOR encoding. For example, unlike the example shown in FIG. 7A in which the read units 751 and 752 include XOR elements, a read circuit 250b illustrated in FIG. 7B may include read units 751b and 752b having XNOR elements. An output waveform of an XNOR element and an output waveform QB of an SR latch in the read circuit 250b may be inverse waveforms, which are inverted from an output waveform of an XOR element and an output waveform Q of an SR latch in the read circuit 250 described above with reference to FIG. 7A. Other operations of the read circuit 250b may be similar to the operations of the read circuit 250 described above with reference to FIG. 7A, and thus will not be described repeatedly. For example, operations 631, 632, 633, 634, and 635 are the same as described above with reference to FIG. 7A and will not be described repeatedly.

Referring to FIG. 6, in operation 636, the memory device (e.g., the memory device 100) may set the latch circuit as a result of an XNOR operation based on a delay difference. In an example, the read circuit 250b may include an XNOR element connected to two neighboring resistive memory cells among N+1 resistive memory cells. FIG. 7B illustrates an example in which a first read unit 751b and a second read unit 752b include respective XNOR elements. For example, the first read unit 751b may output 1 when a resistor value of a first resistive memory element A and a resistor value of a second resistive memory element B are the same, and output 0 when they are different.

Referring to FIG. 7B, a voltage may be provided to an input end of an XNOR element by power driven to a bitline. A time for which the voltage is charged or discharged may vary depending on a resistor value set for a resistive memory cell and a parasitic capacitance formed along the bitline. The XNOR element may output a result (e.g., 1 if equal, 0 if different) of comparing resistor values set for two resistive memory elements through a delay (e.g., a charge delay or discharge delay) that varies according to a resistor value set for each resistive memory element, as described above. For example, each XNOR circuit of the read circuit 250b may output an XNOR output as "0" when a delay difference exceeds a threshold value, and output the XNOR output as "1" when the delay difference is less than or equal to the threshold value.

For example, when resistor values stored in a first resistive memory element A and a second resistive memory element B of a first address A0 among a plurality of wordlines are (R_{P}, R_{AP}), an XNOR element may generate an output pulse corresponding to "0" (or a logic value L) during a delay difference, i.e., t_{AP} - t_{P}. This output pulse may be transferred to a set port of an SR latch in a corresponding read unit. A QB of the SR latch may output a signal corresponding to "0" (or the logic value L). For reference, FIG. 7A illustrates a NOR gate-based SR latch operating in an active-high state (active-High), while FIG. 7B illustrates a not-AND (NAND) gate-based SR latch operating in an active-low state (active-Low). The output pulse generated by the XNOR element may be input to an SN node of the SR latch, and the SR latch of FIG. 7B may generate an output at a QB node.

In an example, when resistor values stored in a first resistive memory element A and a second resistive memory element B of a second address A1, among a plurality of wordlines, are (R_{AP}, R_{P}), the XNOR element may generate an output pulse corresponding to a logic value L during a delay difference, i.e., t_{AP} - t_{P}. The QB node of the SR latch may output a signal corresponding to "0" (or the logic value L).

In an example, when resistor values stored in a first resistive memory element A and a second resistive memory element B of a third address A2 are (R_{P}, R_{P}), the XNOR element may provide a signal corresponding to "1" (or a logic value H). Thus, the SR latch may maintain, at the QB node, a value of 1 (e.g., a signal corresponding to the logic value H) initialized to a reset signal (RN in FIG. 7B). At a fourth address A3, the QB output of the SR latch may also be maintained at 1 because a delay is the same as t_{AP}.

Referring to FIG. 6, in operation 637, the memory device may read an output of the latch circuit with an edge-synchronized clock. For example, the memory device may read a bit value set for the QB node of the SR latch with a clock synchronized with a rising edge and a falling edge of a strobe signal STRB through an input-output logic (IO logic).

FIG. 8 illustrates an example method of setting a resistor value according to one or more embodiments. Referring to FIG. 8, in a non-limiting example, a method of operating a memory device (e.g., memory device 100), for example, a memory encoding method, may be a method of encoding N bits using N+1 memory cells connected to a wordline. For example, the memory encoding method may select one memory cell having a reference resistor value from among the N+1 memory cells. In this example, when, among the N bits, a bit value at a position represented by resistor values of the selected memory cell and its neighboring memory cell is a first value, the memory encoding method may set a resistor value of the neighboring memory cell to be the reference resistor value. When, among the N bits, the bit value at the position represented by the resistor values of the memory cell and the neighboring memory cell is a second value different from the first value, the memory encoding method may set the resistor value of the neighboring memory cell to be a value different from the reference resistor value. Here, N may be an integer greater than or equal to 1.

For example, XOR may have the first value of 0 and the second value of 1. When N is an integer greater than or equal to 2, and a bit value at a specific position is 0, resistor values of two neighboring memory cells representing the bit value at the specific position may be the same. When the bit value at the specific position is 1, the resistor values of the two neighboring memory cells representing the bit value at the specific position may be different.

In an example, XNOR may have the first value of 1 and the second value of 0. When N is an integer greater than or equal to 2, and a bit value at a specific position is 0, resistor values of two neighboring memory cells representing the bit value at the specific position may be different. When the bit value at the specific position is 1, the resistor values of the two neighboring memory cells representing the bit value at the specific position may be the same.

The selected memory cell described above may be an error memory cell (i.e., a cell including a faulty resistive memory element). The reference resistor value may be a fixed resistor value (or a stuck resistor value herein) of the error memory cell. In the memory device including a plurality of the wordlines, column positions of error memory cells of at least two wordlines may be different. Hereinafter, an error repair of the memory device using dynamic selection of the reference memory cell described above will be described.

In an example, in operation 811, the memory device (e.g., the write encoder 273) may generate N+1 write signals respectively indicative of N+1 resistor values representing an N-bit sequence (DATA), determined based on a stuck resistor value of an error memory cell in a wordline including the error memory cell. The error memory cell may be a cell including a faulty resistive memory element, and because of the fault condition, a resistance of the resistive memory element of the error memory cell may not change (or flip). The resistor value of the error memory cell may have a resistor value that is stuck to one of a resistor value R_{P} in a first resistance state (e.g., a low resistance state, LRS) or a resistor value R_{AP} in a second resistance state (e.g., a high resistance state, HRS).

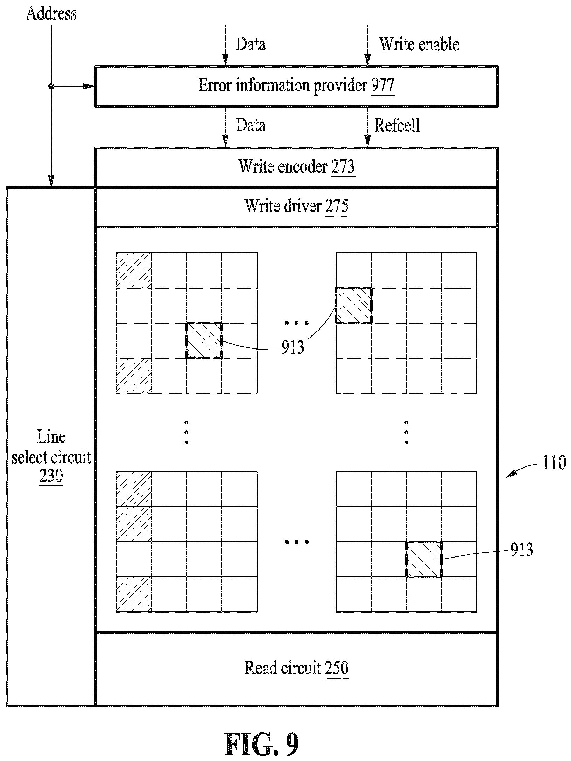

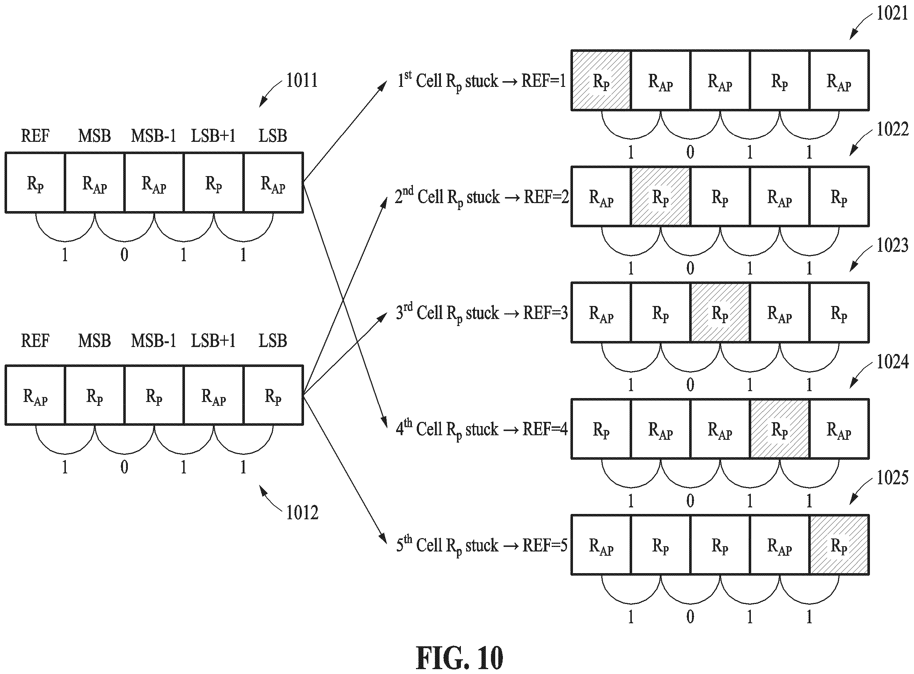

FIGS. 9 and 10 illustrate example setting operations, by a memory device, a resistor value based on an error memory cell according to one or more embodiments.

Referring to FIG. 9, in a non-limiting example, the memory device (e.g., the memory device 100) may include a memory array 110 having an error memory cell 913, a line select circuit 230, a read circuit 250, a write encoder 273, a write driver 275, and an error information provider 977. For reference, in the example illustrated in FIG. 9, portions of the reference write circuit 271 of FIG. 2 may be implemented by being integrated into the write encoder 273 and the write driver 275, respectively.

N+1 resistive memory cells of the memory array 110 may respectively have resistor values determined based on a stuck resistor value of an error memory cell in a wordline including the error memory cell. Normal resistor values may be recorded or written in the memory array 110 by the write encoder 273 that refers to error information (REFCELL). The read circuit 250 may read a resistor value combination based on an XOR operation. Therefore, the presence or absence of an error does not need to be considered in designing the read circuit 250. For example, as illustrated in FIG. 9, the memory array 110 may include the error memory cell 913 at a different position on each wordline. In a wordline that may include a memory cell that is the error memory cell 913, a stuck resistor value and an error occurrence position of the error memory cell 913 may be used for XOR encoding.

The error information provider 977 may provide information about an error memory cell, for example, error information REFCELL. The error information provider 977 may be implemented as, for example, a lookup table (LUT) circuit that provides the error information REFCELL to the write encoder 273.

The write encoder 273 may generate a plurality of write signals for a plurality of resistive memory elements for each wordline by referring to the error information REFCELL. In an example, the write encoder 273 may include a plurality of XOR elements that generate N+1 write signals based on N bit signals respectively indicative of bit values of a bit sequence DATA and on a stuck resistor value.

In an example, the write encoder 273 may generate write signals for setting, for N+1 resistive memory cells of a wordline selected for writing, a resistor value combination matching a stuck resistor value of an error memory cell among two available resistor value combinations representing the bit sequence DATA. The write encoder 273 may determine the resistor value combination to be set for the N+1 resistive memory cells based on the magnitude of the stuck resistor value (e.g., R_{P} or R_{AP}) and a position of the error memory cell in the wordline. Referring to FIG. 10, in a non-limiting example, a bit sequence DATA of 4'b1011 may be represented by a first resistor value combination 1011 of R_{P}R_{AP}R_{AP}R_{P}R_{AP} and a second resistor value combination 1012 of R_{AP}R_{P}R_{P}R_{AP}R_{P}. The 4-bit sequence DATA may be represented by five resistive memory cells. Examples in which a resistor value of one of the five resistive memory cells is stuck to a first resistor value R_{P} are illustrated. In an example, in a first case 1021 where a first cell of the five resistive memory cells is an R_{P} error memory cell (i.e., the error cell being illustrated with cross-hatching), and in a fourth case 1024 where a fourth cell of the five resistive memory cells is the R_{P} error memory cell, the first resistor value combination 1011 may be represented (i.e., the first resistor value combination 1011 may represent the first and fourth case 1021 and 1024). Similarly, in a second case 1022 where a second cell is the R_{P} error memory cell, in a third case 1023 where a third cell is the R_{P} error memory cell, and in a fifth case 1025 where a fifth cell is the R_{P} error memory cell, the second resistor value combination 1012 may be represented (i.e., the second, third and fifth cases 1022, 1023, and 1025 are represented by the second resistor value combination 1012).

Although only the example of the bit sequence DATA of 4'b1011 is described above, a resistor value combination that refers to an error memory cell may also be selected for any bit sequence DATA. For example, in a wordline, a third memory cell (e.g., a resistive memory cell corresponding to COL[2]) may be an error memory cell having a stuck first resistor value R_{P}. Table 6 below provides example resistor value combinations that are mapped for each bit sequence DATA, for a wordline in which the resistive memory cell corresponding to COL[2] has the stuck first resistor value R_{P}.

**Table 6:**

| Original Data | | | | Resistor Value | | | | |
|---|---|---|---|---|---|---|---|---|
| DATA[3] | DATA[2] | DATA[1] | DATA[0] | COL[4] | COL[3] | COL[2] | COL[1] | COL[0] |
| 0 | 0 | 0 | 0 | R_{P} | R_{P} | R_{P} | R_{P} | R_{P} |
| 0 | 0 | 0 | 1 | R_{P} | R_{P} | R_{P} | R_{P} | R_{AP} |
| 0 | 0 | 1 | 0 | R_{P} | R_{P} | R_{P} | R_{AP} | R_{AP} |
| 0 | 0 | 1 | 1 | R_{P} | R_{P} | R_{P} | R_{AP} | R_{P} |
| 0 | 1 | 0 | 0 | R_{AP} | R_{AP} | R_{P} | R_{P} | R_{P} |
| 0 | 1 | 0 | 1 | R_{AP} | R_{AP} | R_{P} | R_{P} | R_{AP} |
| 0 | 1 | 0 | 1 | R_{AP} | R_{AP} | R_{P} | R_{P} | R_{AP} |
| 0 | 1 | 1 | 0 | R_{AP} | R_{AP} | R_{P} | R_{AP} | R_{AP} |
| 0 | 1 | 1 | 1 | R_{AP} | R_{AP} | R_{P} | R_{AP} | R_{P} |
| 1 | 0 | 0 | 0 | R_{AP} | R_{P} | R_{P} | R_{P} | R_{P} |
| 1 | 0 | 0 | 1 | R_{AP} | R_{P} | R_{P} | R_{P} | R_{AP} |
| 1 | 0 | 1 | 0 | R_{AP} | R_{P} | R_{P} | R_{AP} | R_{AP} |
| 1 | 0 | 1 | 1 | R_{AP} | R_{P} | R_{P} | R_{AP} | R_{P} |
| 1 | 1 | 0 | 0 | R_{P} | R_{AP} | R_{P} | R_{P} | R_{P} |
| 1 | 1 | 0 | 1 | R_{P} | R_{AP} | R_{P} | R_{P} | R_{AP} |
| 1 | 1 | 1 | 0 | R_{P} | R_{AP} | R_{P} | R_{AP} | R_{AP} |
| 1 | 1 | 1 | 1 | R_{P} | R_{AP} | R_{P} | R_{AP} | R_{P} |

Thus, a resistor value combination may be selected based on a stuck resistor value of any one of a plurality of resistive memory cells in a wordline, by an XOR encoding-based flexible mapping. In an example, the memory device may record error information REFCELL of an error memory cell, and provide the error information REFCELL to the write encoder 273 to allow the write encoder 273 to use that information for the error memory cell. As described above, the memory device may always be able to determine a correct resistor value combination for any bit sequence DATA, even when the error memory cell is stuck to either the first resistor value or the second resistor value.

Referring to FIG. 8, in operation 813, the write driver 275 may respectively set resistor values according to the N+1 write signals for the N+1 resistive memory cells. For example, the write driver 275 may set the resistor values according to the N+1 write signals for a wordline activated (or enabled) in response to an address of a memory write request.

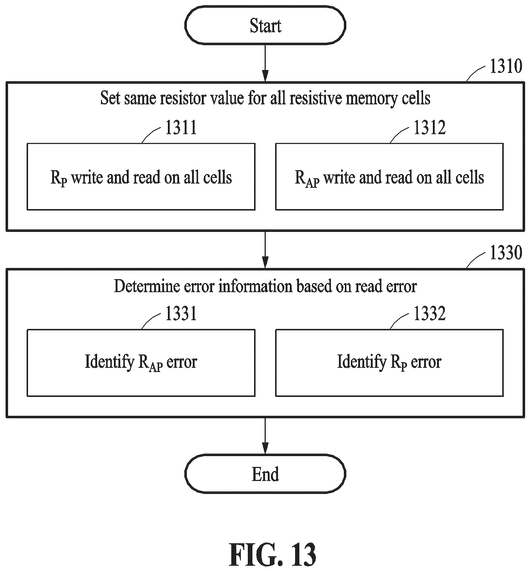

As described above, in an example, using the information of the error memory cell, the memory device may implement a memory repair function without requiring a separate spare memory cell. In contrast, in a example, when a specific memory cell fails and does not operate normally, a memory may require a memory repair circuit. In this case, according to an example, the memory device may consider and use a value of the faulty memory cell, without requiring an additional area, and may thus increase its yield. Further, the memory device may dynamically provide the memory repair function by updating the error information REFCELL through monitoring as described below in greater detail with reference to FIGS. 13 through 16 even though an error in a memory cell occurs during an operation.

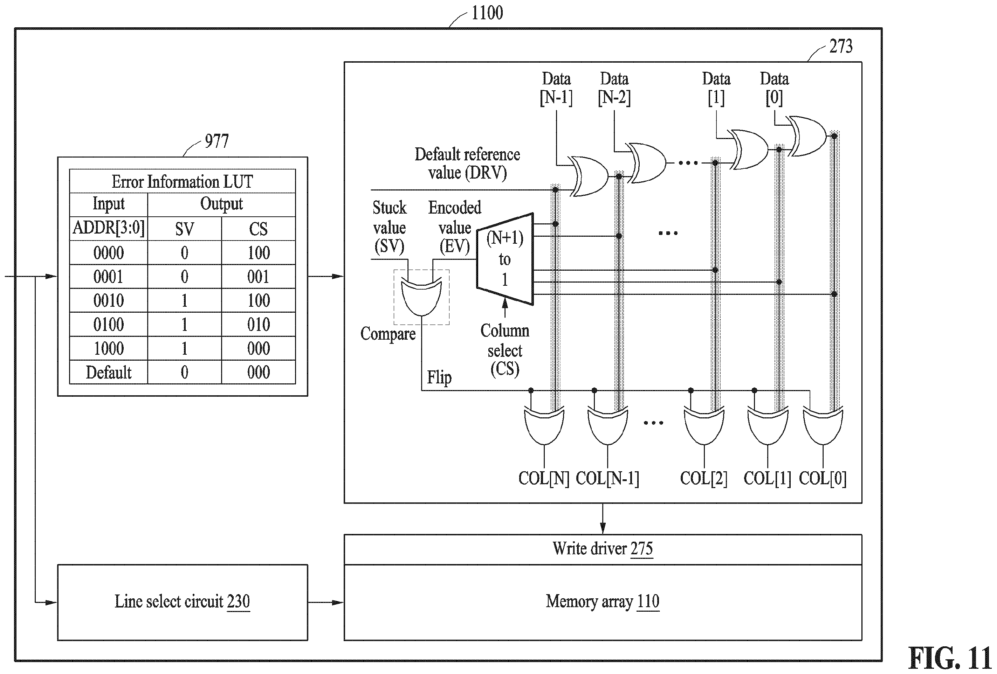

FIGS. 11, and 12A and 12B illustrate example circuits of a write encoder referring to an error memory cell in a memory device according to one or more embodiments.

Referring to FIG. 11, in a non-limiting example, a memory device 1100 may include an error information provider 977, a write encoder 273, a line select circuit 230, a write driver 275, and a memory array 110.

The error information provider 977 may store error information to be provided to the write encoder 273. The error information may be implemented as a LUT. The error information provider 977 may store a stuck value SV (e.g., a value indicative of a stuck resistance magnitude) for each address (ADDR[3:0]) (e.g., an address corresponding to an arbitrary wordline), and an error position value CS. The stuck value SV may be a value indicative of a stuck resistance magnitude (e.g., R_{P} or R_{AP}) of an error memory cell, which may be an error value. The error position value CS (e.g., a column select value) may be a value indicative of a position (e.g., a column position) of a resistive memory cell where an error for which a resistance flip is not available has occurred in a corresponding wordline. A default reference value DRV may be input from a user as a reference value for XOR encoding (or XNOR encoding) as an example but is not limited thereto. The default reference value DRV may be either 0 or 1. An encoding result based on the default reference value DRV and a bit sequence (Data[N-1 :0]) may be used as is, or may be inverted, depending on a result of a comparison between the stuck value SV and an XOR-encoded value (or XNOR-encoded value) (e.g., encoded value EV) of an error occurrence position in the encoding result. For example, when the stuck value SV and the encoded value EV of the error occurrence position are the same, the memory device 1100 may use write signals corresponding to the encoding result. Conversely, when the stuck value SV and the encoded value EV of the error occurrence position are different, the memory device 1100 may use inverse write signals that are inverted from the write signals corresponding to the encoding result. The error information provider 977 may receive an address of a memory write request as an input, and output a stuck value SV corresponding to the address and an error position value CS. Example error information shown in FIG. 11 may represent information about an error memory cell of wordlines corresponding to addresses of "0000," "0001," "0010," "0100," and "1000. For reference, when receiving an address other than a registered address as an input, the error information provider 977 may output, as default information, a stuck value SV of 0 and an error position value CS of "0...00." The construction of the error information will be described below in greater detail with reference to FIGS. 13 through 16.

The write encoder 273 may determine write signals corresponding to one of two resistor value combinations based on a stuck value SV and an error position (e.g., a value indicating a position of an error memory cell in a wordline).

Referring to FIG. 12A, in a non-limiting example, the write encoder 273 may include first XOR elements 1271 and second XOR elements 1273.

The first XOR elements 1271 may generate write signals based on a stuck resistor value and a bit sequence. An XOR gate of the first XOR elements 1271 may output 0 when its inputs are the same and 1 when the inputs are different. An output of at least one of the first XOR elements 1271 may be connected to an input of another first XOR element. The first XOR elements 1271 may be connected sequentially. In an example, except for a first XOR element corresponding to a least significant bit (LSB) of the first XOR elements 1271, outputs of the remaining first XOR elements 1271 may be connected to inputs of other first XOR elements. An XOR element corresponding to a most significant bit (MSB) of the first XOR elements 1271 may generate an XOR result between a default reference value DRV and an MSB value of the bit sequence. A remaining first XOR element may generate an XOR result between an output of another XOR element and a bit value of a corresponding bit position in the bit sequence. The first XOR elements 1271 may generate N write signals. In this case, N+1 write signals that are obtained as the N write signals generated by the first XOR elements 1271 which may be combined with the given default reference value DRV may be a result of XOR encoding performed on an N-bit sequence (or a bit sequence of N bits). However, the write signals corresponding to the result of the XOR encoding may be inverted by the second XOR elements 1273 as described below.

In an example, the same bit sequence may be represented by two resistor value combinations as described above with reference to FIG. 5. The write encoder 273 may use the write signals generated by the first XOR elements 1271 as is or invert them through the second XOR elements 1273. For example, the second XOR elements 1273 may generate inverse write signals that are inverted from the write signals when a value of a write signal corresponding to an error memory cell among the write signals and a stuck resistor value are different. In another example, the second XOR elements 1273 may pass the write signals generated by the first XOR elements 1271, without inversion, when the value of the write signal, corresponding to the error memory cell among the write signals, and the stuck resistor value are the same.

In an example, the write encoder 273 may include a select circuit 1272 that controls the second XOR elements 1273. The select circuit 1272 may operate the second XOR elements 1273 as inverters 1283 based on a comparison between a stuck value SV corresponding to a selected wordline and an encoded value EV of a corresponding error position (e.g., a position in the wordline of a cell where an error has occurred).

For reference, an XOR element may operate as an inverter that, when a value of 1 is given to one of two inputs, the XOR element inverts a value of the other input. The XOR element may also operate as an element 1281 that, when a value of 0 is given to one of two inputs, the XOR element passes a value of the other input as is. Thus, the select circuit 1272 may provide, to the second XOR elements 1273, a signal corresponding to 1 when the stuck value SV and the encoded value EV of the corresponding error position are different, and a signal corresponding to 0 when they are the same.

In an example, the select circuit 1272 may include a comparator XOR gate (comp) and a multiplexer (MUX). The MUX may be an (N+1)-to-1 MUX, which may provide the comparator XOR gate comp with an encoded value EV corresponding to an error position value CS indicated by error information. An output, Flip, of the comparator XOR gate comp may be 0 when the encoded value EV and the stuck value SV are the same and be 1 when they are different. One of two input ends of the second XOR elements 1273 may receive the output Flip of the comparator XOR gate comp. The other of the two input ends of the second XOR elements 1273 may receive the write signals generated by the first XOR elements 1271 described above.

In the example illustrated in FIG. 12A, DATA[N-1:0] may represent a bit sequence of data for which a write request is made. The first XOR elements 1271 may generate write signals corresponding to a result of XOR encoding performed on the bit sequence DATA[N-1:0] based on a default reference value DRV. The stuck value SV may be a fixed resistor value of an error memory cell as described above. The default reference value DRV may be a value on which the XOR encoding by the first XOR elements 1271 is based, as described above. Hereinafter, an operation of a write encoder (e.g., the write encoder 273) using error information will be described.

As described above, the write encoder may generate a write signal indicating a resistor value combination based on a comparison between a stuck value SV and an encoded value EV The encoded value EV may be a value of a write signal for a resistive memory cell at an error position CS at which an error has occurred. The error position value CS may indicate a position of the resistive memory cell where the error has occurred. For example, when the stuck value SV and the encoded value EV are the same (e.g., both are 0 or both are 1), the write signals by the first XOR elements 1271 may be used without inversion. In this case, as shown in FIG. 12A, the second XOR elements 1273 of the write encoder may each be interpreted as the element 1281 that passes the default reference value DRV and outputs of first XOR gates as is. In an example, when the stuck value SV and the encoded value EV are different, the second XOR elements 1273 may transfer, to a write driver, inverse write signals that are inverted from the write signals of the first XOR elements 1271 and an inverse write signal that is inverted from the default reference value DRV In this case, as shown in FIG. 12A, the second XOR elements 1273 of the write encoder may be interpreted as the inverters 1283 that invert the default reference value DRV and the outputs of the first XOR gates.

In an example, final write signals (COL[N:0]) may be the write signals from the first XOR elements 1271 or the inverse write signals from the second XOR elements 1273. The final write signals (COL[N:0]) may be a value indicative of a resistance magnitude to be set for a resistive memory element of a wordline for each column. For example, the resistance magnitude to be set may be R_{P} when a value of a write signal is 0, and the resistance magnitude to be set may be R_{AP} when the value of the write signal is 1. However, examples are not limited thereto, they may be inversely mapped according to a design.

Although FIG. 12A illustrates an example of XOR encoding, examples are not limited thereto. The memory device (e.g., the memory device 100 and/or the write encoder 273) may also determine resistor values of resistive memory elements based on XNOR encoding. Referring to FIG. 12B, in a non-limiting example, the write encoder 273 may include first XNOR elements 1271b and second XNOR elements 1273b.

The first XNOR elements 1271b may generate write signals based on a stuck resistor value and a bit sequence. An XNOR gate of the first XNOR elements 1271b may output 1 when inputs are the same and 0 when the inputs are different. An output of at least one of the first XNOR elements 1271b may be connected to an input of another first XNOR element. The first XNOR elements 1271b may be connected sequentially. In an example, except for a first XNOR element corresponding to an LSB of the first XNOR elements 1271b, outputs of the remaining first XNOR elements 1271b may be connected to inputs of other first XNOR elements. An XNOR element corresponding to an MSB of the first XNOR elements 1271b may generate an XNOR result between a default reference value DRV and an MSB value of the bit sequence. A remaining first XNOR element may generate an XNOR result between an output of another XNOR element and a bit value of a corresponding bit position in the bit sequence. The first XNOR elements 1271b may generate N write signals. N+1 write signals that are obtained as the N write signals generated by the first XNOR elements 1271b are combined with the given default reference value DRV may be a result of XNOR encoding performed on an N-bit sequence (or a bit sequence of N bits). However, the write signals corresponding to the result of the XNOR encoding may be inverted by the second XNOR elements 1273b described below.

In an example, the same bit sequence may be represented by two resistor value combinations as described above with reference to FIG. 5. The write encoder 273 may use the write signals generated by the first XNOR elements 1271b as is or invert them through the second XNOR elements 1273b. For example, the second XNOR elements 1273b may generate inverse write signals that are inverted from the write signals, when a value of a write signal, corresponding to an error memory cell among the write signals, and a stuck resistor value are different. In another example, the second XNOR elements 1273b may pass the write signals generated by the first XNOR elements 1271b, without inversion, when the value of the write signal, corresponding to the error memory cell among the write signals, and the stuck resistor value are the same.

In an example, the write encoder 273 may include a select circuit 1272b that controls the second XNOR elements 1273b. The select circuit 1272b may operate the second XNOR elements 1273b as inverters 1283b based on a comparison between a stuck value SV corresponding to a selected wordline and an encoded value EV of a corresponding error position (e.g., a position in the wordline of a cell where an error has occurred).

For reference, an XNOR element may operate as an inverter that, when 0 is given to one of two inputs, inverts a value of the other input. The XNOR element may also operate as an element 1281b that, when 1 is given to one of two inputs, passes a value of the other input as is. Thus, the select circuit 1272b may provide, to the second XNOR elements 1273b, a signal corresponding to 0 when the stuck value SV and the encoded value EV of the corresponding error position are different, and a signal corresponding to 1 when they are the same.

In an example, the select circuit 1272b may include a comparator XNOR gate (compb) and a MUX. The MUX may be an (N+1)-to-1 MUX, which may provide the comparator XNOR gate compb with an encoded value EV corresponding to an error position value CS indicated by error information. An output, Flip, of the comparator XNOR gate compb may be 1 when the encoded value EV and the stuck value SV are the same and be 0 when they are different. One of two input ends of the second XNOR elements 1273b may receive the output Flip of the comparator XNOR gate compb. The other of the two input ends of the second XNOR elements 1273b may receive the write signals generated by the first XNOR elements 1271b as described above.

In the example illustrated in FIG. 12B, DATA[N-1:0] may represent a bit sequence of data for which a write request is made. The first XNOR elements 1271b may generate write signals corresponding to a result of XNOR encoding performed on the bit sequence DATA[N-1:0] based on a default reference value DRV The stuck value SV may be a fixed resistor value of an error memory cell as described above. The default reference value DRV may be a value on which the XNOR encoding by the first XNOR elements 1271b is based, as described above. Hereinafter, an operation of a write encoder (e.g., the write encoder 273) using error information will be described.

As described above, the write encoder may generate a write signal indicating a resistor value combination based on a comparison between a stuck value SV and an encoded value EV The encoded value EV may be a value of a write signal for a resistive memory cell at an error position CS at which an error has occurred. The error position value CS may indicate a position of the resistive memory cell where the error has occurred. For example, when the stuck value SV and the encoded value EV are the same (e.g., both are 0 or both are 1), the write signals by the first XNOR elements 1271b may be used without inversion. In this case, as illustrated in FIG. 12B, the second XNOR elements 1273b of the write encoder may each be interpreted as the element 1281b that passes the default reference value DRV and outputs of first XNOR gates. In another example, when the stuck value SV and the encoded value EV are different, the second XNOR elements 1273b may transfer, to a write driver, inverse write signals that are inverted from the write signals of the first XNOR elements 1271b and an inverse write signal that is inverted from the default reference value DRV In this case, as illustrated in FIG. 12B, the second XNOR elements 1273b of the write encoder may be interpreted as the inverters 1283b that invert the default reference value DRV and the outputs of the first XOR gates.

Final write signals (COL[N:0]) may be the write signals from the first XNOR elements 1271b or the inverse write signals from the second XNOR elements 1273b. The final write signals (COL[N:0]) may be a value indicative of a resistance magnitude to be set for a resistive memory element of a wordline for each column. For example, the resistance magnitude to be set may be R_{P} when a value of a write signal is 0, and the resistance magnitude to be set may be R_{AP} when the value of the write signal is 1. However, examples are not limited thereto, and they may be inversely mapped according to a design.

FIG. 13 illustrates an example method generating error information according to one or more embodiments.

In an example, the memory device (e.g., the memory device 100) may manage error information. The error information may be prepared during a manufacturing and processing step of the memory device. During the manufacturing and processing step, a memory array may be subjected to the tests described in greater detail below with reference to FIGS. 13 through 16 for detecting an error memory cell. However, examples are not limited thereto. The memory device may also collect and update the error information while monitoring the memory array. For example, the memory device may periodically update the error information using a result of setting and reading resistor values of a first resistance state for a plurality of resistive memory cells in the memory array and a result of setting and reading resistor values of a second resistance state for the plurality of resistive memory cells in the memory array. Example error detection operations will be described in greater detail below with reference to FIGS. 13 through 15.

Referring to FIG. 13, in a non-limiting example, in operation 1310, the memory device (e.g., the memory device 100) may set the same resistor value for all resistive memory cells. The memory device may set resistor values of a first resistance state corresponding to a first bit value (e.g., a bit value of 0) for resistive memory cells of the memory array.

For example, in operation 1311, the memory device (e.g., the memory device 100) may perform R_{P} writing and reading on all the cells.

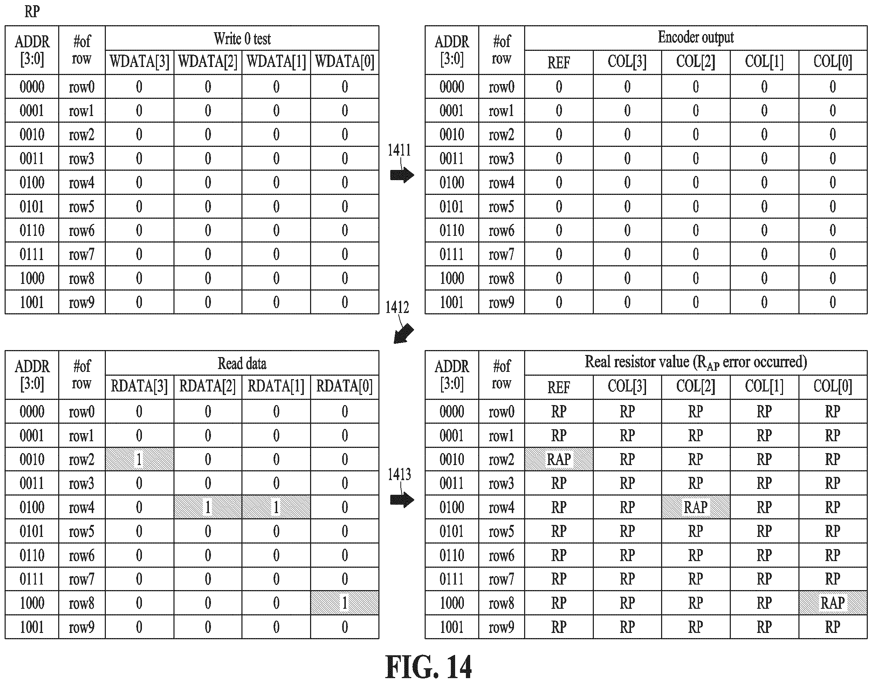

FIGS. 14 through 16 illustrate examples of generating error information according to one or more embodiments.

Referring to FIG. 14, in a non-limiting example, a memory device (e.g., the memory device 100) may generate write signals (e.g., "0000") with R_{P} as a reference resistor value from a bit sequence indicating 0. The memory device may attempt to set a resistor value (e.g., R_{P}) corresponding to the generated write signals for all resistive memory cells, as indicated by reference numeral 1411. In the example illustrated in FIG. 14, a resistor value of the first resistance state may be R_{P}. The memory device may perform XOR encoding-based reading (e.g., reading described above with reference to FIGS. 4 through 7) on the resistive memory cells for which resistor values are set, as indicated by reference numeral 1412. Since the original bit sequence is "0000," a result of the reading may all be "0000," but when an error memory cell is present, "1" may be read from one or two adjacent bit positions relative to the error memory cell.

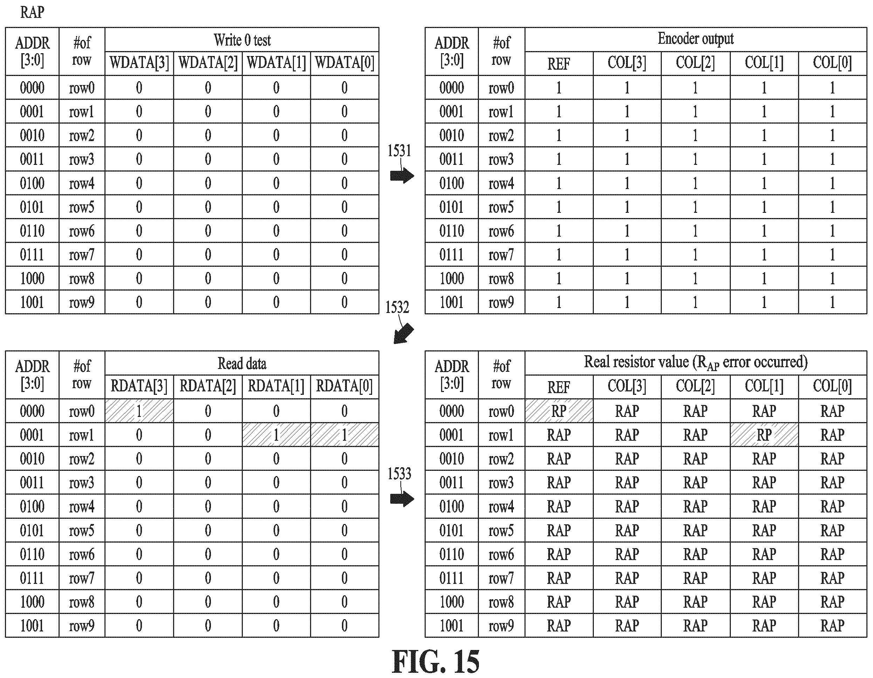

In an example, in operation 1312, the memory device may perform R_{AP} writing and reading on all the cells. Referring to FIG. 15, in a non-limiting example, the memory device (e.g., the memory device 100) may generate write signals (e.g., "0000") with R_{AP} as a reference resistor value from a bit sequence indicating 0. The memory device may attempt to set a resistor value (e.g., R_{AP}) corresponding to the generated write signals for all resistive memory cells, as indicated by reference numeral 1531. In the example shown in FIG. 15, a resistor value of the first resistance state may be R_{AP}. The memory device may perform XOR encoding-based reading (e.g., reading described above with reference to FIGS. 4 through 7) on the resistive memory cells for which resistor values are set, as indicated by reference numeral 1532. Since the original bit sequence is "0000," a result of the reading may all be "0000," but when an error memory cell is present, "1" may be read from one or two adjacent bit positions relative to the error memory cell.

Referring to FIG. 13, in operation 1330, the memory device may determine error information based on a read error. For example, the memory device may determine a resistive memory cell corresponding to a portion from which a second bit value (e.g., a bit value of "1") is read among the resistive memory cells as an error memory cell.

In operation 1331, the memory device (e.g., the memory device 100) may identify an R_{AP} error. For example, referring to FIG. 14, the memory device may determine a position of the error memory cell corresponding to a bit position where a bit error has occurred, as indicated by reference numeral 1413. In the example illustrated in FIG. 14, a result of RDATA[3]='1' where an R_{P} writing has been attempted may indicate that a resistor value of REF (or COL[4]) is R_{AP}. A result of RDATA[2:1]='11' may indicate that a resistor value of COL[2] is R_{AP}. A result of RDATA[0]='1' may indicate that a resistor value of COL[0] is R_{AP}.

In operation 1332, the memory device (e.g., the memory device 100) may identify an R_{P} error. For example, referring to FIG. 15, the memory device may determine a position of an error memory cell corresponding to a bit position where a bit error has occurred, as indicated by reference numeral 1533. In the example illustrated in FIG. 15, a result of RDATA[3]='1' may indicate that a resistor value of REF (or COL[4]) is Rp. A result of RDATA[1: 0]='11' may indicate that a resistor value of COL[1] is Rp.

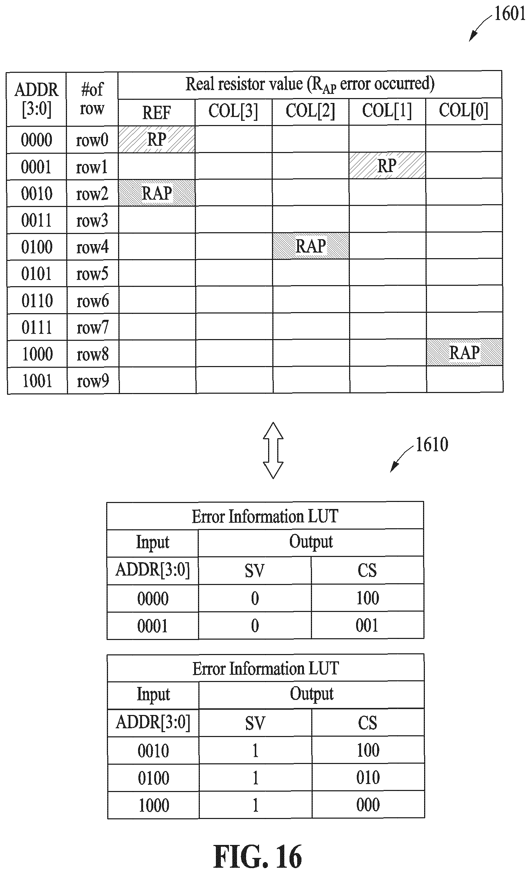

The memory device (e.g., the memory device 100) may manage the error memory cell as having a resistor value of a second resistance state. The resistor value of the second resistance state may be R_{AP} in the example illustrated in FIG. 14, and the resistor value of the second resistance state may be R_{P} in the example illustrated in FIG. 15. The memory device may record (or write), in error information, a value indicative of a wordline in which the error memory cell is located (e.g., an address corresponding to the wordline), a value indicative of a column line in which the error memory cell is located (e.g., an error position value), and a stuck resistor value of the error memory cell. As described above, the memory device may have a plurality of wordlines including the wordline. A column line in which an error memory cell of a first wordline among the plurality of wordlines is located may be different from a column line in which an error memory cell of a second wordline among the plurality of wordlines is located. The memory device may manage the error information separately for each wordline in which an error occurs. The memory device may selectively determine a memory cell in which an error has occurred for each wordline. Referring to FIG. 16, in a non-limiting example, a memory device (e.g., the memory device 100) may identify a position at which an R_{P} error has occurred and a position at which an R_{AP} error has occurred as a result 1601 of error detection described above with reference to FIGS. 14 and 15. The memory device may update, for example, through the error information provider 977, and manage error information 1610 including an address, a stuck value SV, and an error position value CS for each error. The error information 1610 may be used by an error information provider described above.

For example, in the example illustrated in FIG. 16, in the error position value CS, "100," "011," "010," "001," and "000" may indicate a resistive memory cell (as a default reference memory cell) on a first column line, a resistive memory cell on a second column line, a resistive memory cell on a third column line, a resistive memory cell on a fourth column line, and a resistive memory cell on a fifth column line, respectively. However, the error position value CS is not limited to the preceding example.

In an example, when an error (e.g., a non-flip resistance error) that prevents a resistive memory cell from being programmed occurs, the memory device (e.g., the memory device 100 and/or the write encoder 273) may record (or write) a stuck resistor value of the resistive memory cell on a corresponding wordline. Based on the stuck resistor value, the memory device may determine a resistor value combination set for resistive memory cells arranged on the corresponding wordline, and thus an automatic memory repair function may be implemented. Therefore, in an example, an issue of a fault with a resistor value being stuck may be solved without requiring additional elements, devices, and/or an area overhead.

The electronic devices, memory device, circuits, XNOR elements, XOR elements, memories, processors, non-volatile memory device 100, memory array 111, write circuit 270, reference write circuit 271, write encoder 273, write drive 275, line select circuit 230, wordline driver 231, address decoder 232, read circuit 250, read circuit 250b, read pulse generator 710, reset generator 731, read units 751, 752, 751b, and 752b, error information provider 977, memory device 1100, first XOR elements 1271 and 1271b, second XOR elements 1273 and 1273b, inverters 1283 and 1283b, elements 1281 and 1281b, select circuits 1272 and 1272b, electronic device 1900, memory 1910, and processor 1920 described herein and disclosed herein described with respect to FIGS. 1-18 are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-18 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks , and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the disclosure is specified by the enclosed claims.

## Claims

1. An apparatus, comprising:
a memory array comprising N+1 resistive memory cells, the N+1 resistive memory cells including resistor values representing an N-bit sequence, the resistor values being determined based on a stuck resistor value of an error memory cell on a wordline comprising the error memory cell, the resistor values being set respectively; and
a write encoder configured to generate N+1 write signals respectively indicative of the resistor values to be set for the N+1 resistive memory cells,
wherein N is an integer greater than or equal to 1.

2. The apparatus of claim 1, wherein, when a bit value at a bit position in the bit sequence is a first bit value, resistor values of neighboring memory elements corresponding to the bit position among the N+1 resistive memory cells are a same value, and
wherein, when the bit value at the bit position is a second bit value, the resistor values of the neighboring memory elements corresponding to the bit position among the N+1 resistive memory cells are different values.

3. The apparatus of claim 1 or 2, wherein the write encoder comprises:
a plurality of exclusive-OR, XOR, elements configured to generate the N+1 write signals based on N bit signals respectively indicative of bit values of the bit sequence and on the stuck resistor value, or
wherein the write encoder is configured to generate write signals for setting, for selected N+1 resistive memory cells of a wordline selected for writing, a resistor value combination matching the stuck resistor value of the error memory cell among two available resistor value combinations representing the bit sequence, or
wherein the write encoder is configured to calculate a resistor value combination to be set for the N+1 resistive memory cells based on a magnitude of the stuck resistor value and a position of the error memory cell in the wordline.

4. The apparatus of claim 1, wherein the write encoder comprises:
first XOR elements configured to generate write signals based on the stuck resistor value and the bit sequence; and
second XOR elements configured to generate inverse write signals, the inverse write signals being inverted from the write signals, in response to a value of a write signal corresponding to the error memory cell among the write signals being a different value from the stuck resistor value, and
wherein the second XOR elements are configured to pass the write signals, in response to the value of the write signal corresponding to the error memory cell among the write signals being a same value as the stuck resistor value.

5. The apparatus of one of claims 1 to 4, wherein the apparatus is further configured to:
set, for resistive memory cells of the memory array, resistor values of a first resistance state corresponding to a first bit value;
determine, as the error memory cell, a resistive memory cell corresponding to a portion of the resistive memory cells from which a second bit value is read, from among the resistive memory cells; and
manage the error memory cell as having a resistor value of a second resistance state.

6. The apparatus of one of claims 1 to 5, wherein the apparatus is further configured to:
record, in error information, a value indicative of the wordline in which the error memory cell is located, a value indicative of a column line in which the error memory cell is located, and the stuck resistor value of the error memory cell, and
periodically update the error information using a first result of setting and reading a resistor value of a first resistance state and a second result of setting and reading a resistor value of a second resistance state, for a plurality of resistive memory cells of the memory array.

7. The apparatus of one of claims 1 to 6, further comprising a plurality of wordlines comprising the wordline,
wherein a column line on which a first error memory cell of a first wordline among the plurality of wordlines is located and a column line on which a second error memory cell of a second wordline among the plurality of wordlines is located are different locations.

8. The apparatus of one of claims 1 to 7, further comprising:
read circuitry, the read circuitry configured to generate bit read signals based on results of XOR performed on resistor values set for the N+1 resistive memory cells disposed along a wordline selected for reading,
wherein the read circuitry comprises an XOR element connected to two neighboring resistive memory cells among the N+1 resistive memory cells, and
wherein the read circuitry is configured to output, as a bit value for the two neighboring resistive memory cells among the N+1 resistive memory cells, a result of comparing delays occurring in the two neighboring resistive memory cells, based on resistor values set for the two neighboring resistive memory cells and a parasitic capacitance.

9. A processor-implemented method, the method comprising:
generating N+1 write signals respectively indicative of N+1 resistor values representing an N-bit sequence, determined based on a stuck resistor value of an error memory cell on a wordline comprising the error memory cell of a memory array; and
setting resistor values according to the N+1 write signals for the N+1 resistive memory cells respectively.

10. The method of claim 9, wherein the generating of the N+1 write signals comprises one of:
generating the N+1 write signals based on N bit signals respectively indicative of bit values of the bit sequence and on the stuck resistor value, and wherein N is an integer greater than or equal to 1,
generating write signals indicative of a resistor value combination matching the stuck resistor value of the error memory cell among two available resistor value combinations representing the bit sequence, and
inverting the write signals, in response to a value of an error write signal corresponding to the error memory cell among the write signals and the stuck resistor value being different values.

11. The method of claim 9 or 10, further comprising setting, for resistive memory cells of the memory array, resistor values of a first resistance state corresponding to a first bit value, determining, as the error memory cell, a resistive memory cell corresponding to a portion of the resistive memory cells from which a second bit value is read, from among the resistive memory cells, and managing the error memory cell as having a resistor value of a second resistance state, or
further comprising generating N bit read signals based on results of an exclusive-OR, XOR, operation performed on resistor values set for the N+1 resistive memory cells disposed along a wordline selected for reading.

12. A computer-readable storage medium storing instructions that, when executed by a processor, cause the processor to perform a method comprising the steps of:
selecting one memory cell, of N+1 memory cells connected to a wordline, having a reference resistor value from among the N+1 memory cells;
setting a resistor value of the neighboring memory cell as the reference resistor value, responsive to a bit value at a position, among the N bits, represented by resistor values of the selected one memory cell and a neighboring memory cell being a first value; and
setting the resistor value of the neighboring memory cell as a value different from the reference resistor value, responsive to the bit value at the position, among the N bits, represented by the resistor values of the selected one memory cell and the neighboring memory cell being a second value different from the first value.

13. The computer-readable storage medium of claim 12, wherein the resistor value has a value encoded based on an exclusive-OR, XOR, in which the first value is zero (0) and the second value is 1, or
wherein the resistor value has a value encoded based on an exclusive-NOR, XNOR, in which the first value is 1 and the second value is 0.

14. The computer-readable storage medium of claim 12, wherein N is an integer greater than or equal to 2, wherein, when a bit value at a position is 0, resistor values of two neighboring memory cells representing the bit value at the position are a same value, and wherein, when the bit value at the position is 1, the resistor values of the two neighboring memory cells representing the bit value at the position are different values, or
wherein N is an integer greater than or equal to 2, wherein, when a bit value at a position is 0, resistor values of two neighboring memory cells representing the bit value at the position are different values, and wherein, when the bit value at the position is 1, the resistor values of the two neighboring memory cells representing the bit value at the position are a same value.

15. The computer-readable storage medium of claim 12, wherein the one selected memory cell is an error memory cell,
wherein the reference resistor value is a stuck resistor value of the error memory cell, wherein N is an integer greater than or equal to 1, and
wherein, in a memory device comprising a plurality of wordlines, column positions of error memory cells of at least two wordlines are different.
